# EUROPEAN PATENT APPLICATION

(11) **EP 4 672 915 A1**
(43) Date of publication of application: **31.12.2025**
(21) Application number: 25182915.6
(22) Date of filing: 16.06.2025
(51) Int. Cl.: H10D 84/01, H10D 30/00, H10D 84/83

(54) **INTEGRATED CIRCUIT DEVICE**

(30) Priority: 27.06.2024 KR 20240084824
(71) Applicant: Samsung Electronics Co., Ltd., Suwon-si, Gyeonggi-do 16677 (KR)
(72) Inventor: YANG, Youngjin, 16677 Suwon-si, Gyeonggi-do (KR); KIM, Hongshin, 16677 Suwon-si, Gyeonggi-do (KR); YANG, Nakyoung, 16677 Suwon-si, Gyeonggi-do (KR)
(74) Representative: Kuhnen & Wacker Patent- und Rechtsanwaltsbüro PartG mbB

(57) **Abstract**

An integrated circuit device (10) includes a hammer-shaped sheet separation wall (SW1, SW2) between nanosheet stack structures (NSS1, NSS2), thereby improving a patterning margin of a gate electrode (GE) and preventing or reducing an effective channel width from being decreased. That is, the integrated circuit device (10) may provide increased stable performance and improved reliability in a nanosheet field-effect transistor.

## Description

### BACKGROUND

The inventive concepts relate to integrated circuit devices, and more particularly, to integrated circuit devices including a field-effect transistor.

With the rapid down-scaling of integrated circuit devices in recent years, it is desirable to ensure not only the speed of operation but also the accuracy of operation in integrated circuit devices. Also, as the degrees of integration of such integrated circuit devices increase and the sizes thereof decrease, the possibility of process defects occurring during manufacturing of nanosheet field-effect transistors may increase. Accordingly, there is a need to develop integrated circuit devices having novel structures that may eliminate or reduce the possibility of process defects and improve the performance and reliability of nanosheet field-effect transistors.

### SUMMARY

The inventive concepts provide integrated circuit devices that may provide increased stable performance and improved reliability in nanosheet field-effect transistors.

The objects of the inventive concepts are not limited to the object mentioned above, but other objects not described herein will be clearly understood by those skilled in the art from the following description.

According to some aspects of the inventive concepts, there is provided an integrated circuit device including a base substrate layer including a pair of first fin-type active regions and a single second fin-type active region, each extending in a first horizontal direction and protruding in a vertical direction, the pair of first fin-type active regions and the single second fin-type active region spaced apart from each other in a second horizontal direction intersecting the first horizontal direction, a first liner pattern extending in the second horizontal direction between the pair of first fin-type active regions and in contact with facing sidewalls of the pair of first fin-type active regions, a second liner pattern extending in the second horizontal direction and in contact with one sidewall of the single second fin-type active region, a first sheet separation wall on the first liner pattern and including a body having a first width and a head having a second width greater than the first width, a second sheet separation wall on the second liner pattern and including a body having a third width and a head having a fourth width greater than the third width, a pair of first nanosheet stack structures each including a plurality of first nanosheets, the pair of first nanosheet stack structures respectively above the pair of first fin-type active regions and spaced apart from each other in the second horizontal direction with the first sheet separation wall therebetween, a single second nanosheet stack structure including a plurality of second nanosheets, the second nanosheet stack structure above the single second fin-type active region, a plurality of indent spacers between the plurality of first nanosheets and the first sheet separation wall and between the plurality of second nanosheets and the second sheet separation wall, a pair of first gate electrodes respectively surrounding the pair of first nanosheet stack structures with the first sheet separation wall therebetween, and a single second gate electrode surrounding the single second nanosheet stack structure.

According to some aspects of the inventive concepts, there is provided an integrated circuit device including a base substrate layer including a pair of fin-type active regions each extending in a first horizontal direction and protruding in a vertical direction, the pair of fin-type active regions spaced apart from each other in a second horizontal direction intersecting the first horizontal direction, a liner pattern extending in the second horizontal direction between the pair of fin-type active regions and in contact with facing sidewalls of the pair of fin-type active regions, a sheet separation wall extending in the first horizontal direction on the liner pattern and including a body having a first width and a head having a second width greater than the first width, a pair of nanosheet stack structures each including a plurality of nanosheets, the pair of nanosheet stack structures respectively above the pair of fin-type active regions and spaced apart from each other in the second horizontal direction with the sheet separation wall therebetween, a plurality of indent spacers between the plurality of nanosheets and the sheet separation wall, and a pair of gate electrodes surrounding the pair of nanosheet stack structures and the plurality of indent spacers with the sheet separation wall therebetween.

According to some aspects of the inventive concepts, there is provided an integrated circuit device including a base substrate layer including a fin-type active region extending in a first horizontal direction and protruding in a vertical direction, a liner pattern in contact with one sidewall of the fin-type active region and extending in a second horizontal direction intersecting the first horizontal direction, a sheet separation wall extending in the first horizontal direction on the liner pattern and including a body having a first width and a head having a second width greater than the first width, a nanosheet stack structure above the fin-type active region and including a plurality of nanosheets, a plurality of indent spacers between the plurality of nanosheets and one sidewall of the sheet separation wall, and a first gate electrode and a second gate electrode, spaced apart from each other in the second horizontal direction with the sheet separation wall therebetween, the first gate electrode surrounding the nanosheet stack structure, and the second gate electrode not surrounding the nanosheet stack structure.

For example, the integrated circuit device has hammer-shaped sheet separation wall(s) between nanosheet stack structures, thereby improving a patterning margin of a gate electrode and preventing or reducing an effective channel width from being decreased. That is, the integrated circuit device may provide increased stable performance and improved reliability in a nanosheet field-effect transistor.

### BRIEF DESCRIPTION OF THE DRAWINGS

Embodiments will be more clearly understood from the following detailed description taken in conjunction with the accompanying drawings in which:
FIG. 1 is a cross-sectional view showing an integrated circuit device according to some example embodiments;
FIGS. 2 and 3 are cross-sectional views showing integrated circuit devices according to some example embodiments;
FIGS. 4 to 32B are perspective views and cross-sectional views showing a method of manufacturing an integrated circuit device in a process sequence, according to some example embodiments; and
FIGS. 33 to 36 are cross-sectional views showing a method of manufacturing an integrated circuit device in a process sequence, according to some example embodiments.

### DETAILED DESCRIPTION

Hereinafter, some example embodiments is described in detail with reference to the accompanying drawings.

For reference, integrated circuit devices 10, 20, and 30 according to the inventive concepts may include both a gate region (a region of line A-A') and a source/drain region (a region of line B-B'). However, for convenience of description, only one of the two regions may be illustrated and described.

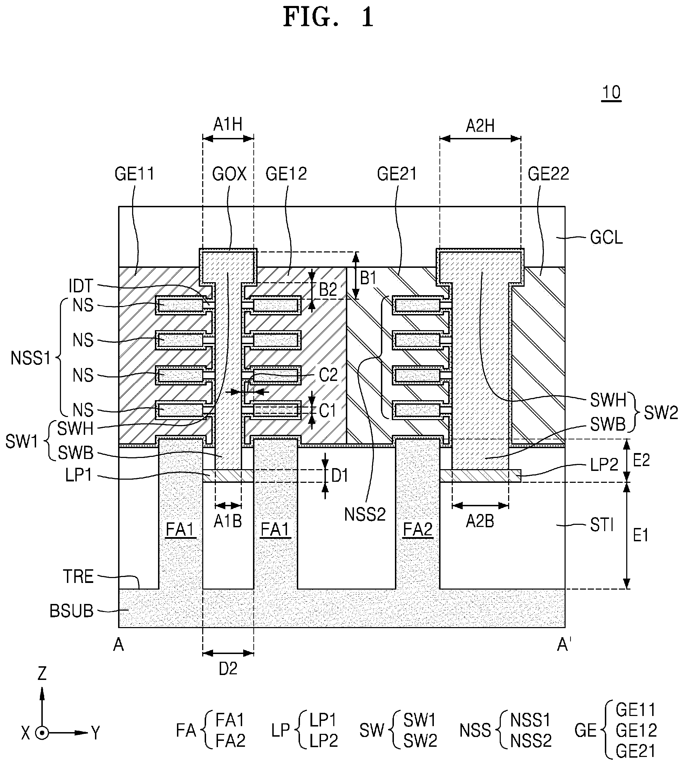

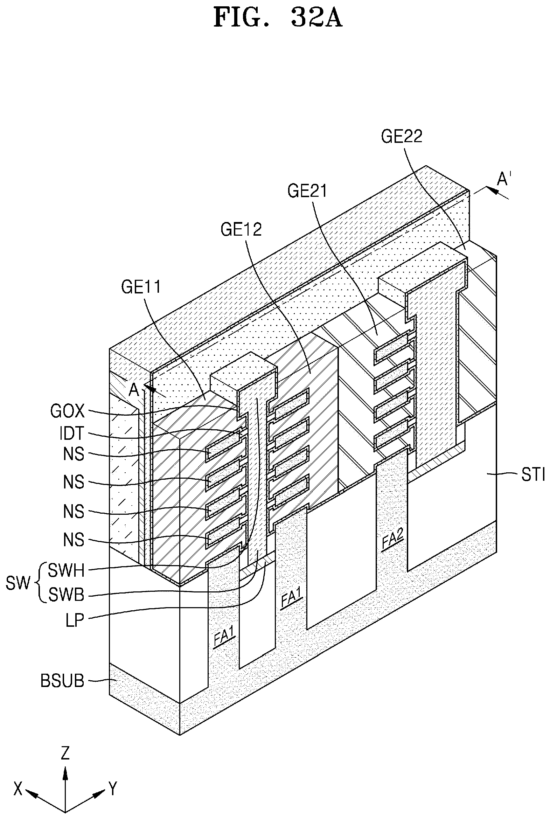

FIG. 1 is a cross-sectional view showing an integrated circuit device 10 according to some example embodiments. Specifically, FIG. 1 is a cross-sectional view of the integrated circuit device 10, corresponding to a cross-section taken along line A-A' of FIG. 32A.

Referring to FIG. 1, the integrated circuit device 10 according to the inventive concepts may include a field-effect transistor that has a plurality of nanosheets NS spaced apart from each other in a vertical direction (a Z direction).

Specifically, components constituting the integrated circuit device 10 according to the inventive concepts are described as follows.

A base substrate layer BSUB may include semiconductor materials, such as silicon (Si) and germanium (Ge), or compound semiconductor materials, such as silicon germanium (SiGe), silicon carbide (SiC), gallium arsenide (GaAs), indium arsenide (InAs), and/or indium phosphide (InP).

A trench isolation STI may be placed within a plurality of trenches TRE of the base substrate layer BSUB. The trench isolation STI may define a plurality of fin-type active regions FA, which is described below.

The plurality of fin-type active regions FA may include a pair of first fin-type active regions FA1, which extend in a first horizontal direction (an X direction), are spaced apart from each other in a second horizontal direction (a Y direction) intersecting the first horizontal direction (the X direction), and protrude in a vertical direction (a Z direction), and a single second fin-type active region FA2, which extends in the first horizontal direction (the X direction) and protrudes in the vertical direction (the Z direction).

A plurality of liner patterns LP may include a first liner pattern LP1, which extends in the second horizontal direction (the Y direction) between the pair of first fin-type active regions FA1, is in contact with the facing sidewalls of the pair of first fin-type active regions FA1, and a second liner pattern LP2, which extends in the second horizontal direction (the Y direction) and is in contact with one sidewall of the single second fin-type active region FA2.

The plurality of sheet separation walls SW may include a first sheet separation wall SW1, which is located on the first liner pattern LP1 and includes a body SWB having a first width A1B and a head SWH having a second width A1H greater than the first width A1B, and a second sheet separation wall SW2, which is disposed on the second liner pattern LP2 and includes a body SWB having a third width A2B and a head SWH having a fourth width A2H greater than the third width A2B.

In some example embodiments, the bodies SWB of the plurality of sheet separation walls SW may each have a rectangular shape with longer sides in the vertical direction (the Z direction), and the heads SWH of the plurality of sheet separation walls SW may each have a rectangular shape with longer sides in the second horizontal direction (the Y direction). In other words, each of the plurality of sheet separation walls SW may have a hammer shape.

In some example embodiments, the first width A1B of the body SWB of the first sheet separation wall SW1 may be less than the third width A2B of the body SWB of the second sheet separation wall SW2, and the second width A1H of the head SWH of the first sheet separation wall SW1 may be less than the fourth width A2H of the head SWH of the second sheet separation wall SW2. This may be because a nanosheet stack structure NSS described below is not formed on one side (the far right side in the diagram) of the second sheet separation wall SW2, and thus, a space in which the second sheet separation wall SW2 may be formed increases.

In some example embodiments, each of the plurality of liner patterns LP may have a rectangular shape with longer sides in the second horizontal direction (the Y direction). The horizontal width of the first liner pattern LP1 in the second horizontal direction (the Y direction) may be equal to the second width A1H of the head SWH of the first sheet separation wall SW1, and the horizontal width of the second liner pattern LP2 in the second horizontal direction (the Y direction) may be equal to the fourth width A2H of the head SWH of the second sheet separation wall SW2. This may be due to the characteristics of a manufacturing process described below.

A plurality of nanosheet stack structures NSS may include a pair of first nanosheet stack structures NSS1, each of which includes a plurality of nanosheets NS and which are disposed respectively above the pair of first fin-type active regions FA1 and spaced apart from each other in the second horizontal direction (the Y direction) with the first sheet separation wall SW1 therebetween, and a single second nanosheet stack structure NSS2, which includes a plurality of nanosheets NS and is disposed above the single second fin-type active region FA2.

A plurality of indent spacers IDT may be arranged between the plurality of nanosheets NS and the first sheet separation wall SW1 and between the plurality of nanosheets NS and the second sheet separation wall SW2.

A plurality of gate electrodes GE may include a pair of first gate electrodes GE11 and GE12, which respectively surround the pair of first nanosheet stack structures NSS1 with the first sheet separation wall SW1 therebetween, a single second gate electrode GE21, which surrounds the single second nanosheet stack structure NSS2, and a single electrode structure GE22.

In some example embodiments, the single electrode structure GE22 may not surround the plurality of nanosheets NS. That is, unlike the single second gate electrode GE21, the single electrode structure GE22 may not function as a gate electrode.

In some example embodiments, the vertical level of the uppermost surface of each of the plurality of gate electrodes GE may be lower than the vertical level of the uppermost surface of each of the heads SWH of the plurality of sheet separation walls SW and higher than the vertical level of the lowermost surface of each of the heads SWH of the plurality of sheet separation walls SW.

A gate capping layer GCL may cover the plurality of gate electrodes GE and the plurality of sheet separation walls SW. Specifically, the gate capping layer GCL may cover the upper surface and a portion of the sidewall of each of the heads SWH of the plurality of sheet separation walls SW.

A gate dielectric film GOX may be conformally arranged between the plurality of gate electrodes GE and the plurality of nanosheet stack structures NSS including the plurality of nanosheets NS and between the plurality of gate electrodes GE and the plurality of fin-type active regions FA.

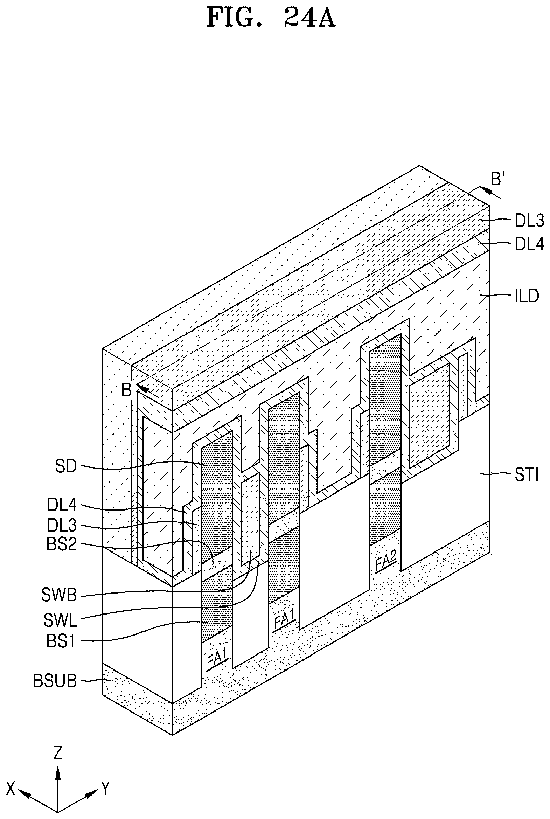

Although not shown in FIG. 1, a plurality of sources/drains SD (see FIG. 24A) may be connected to the plurality of nanosheets NS in the plurality of nanosheet stack structures NSS. This is described below in detail.

That is, in the integrated circuit device 10 according to the inventive concepts, the plurality of nanosheet stack structures NSS, the plurality of gate electrodes GE, and the plurality of sources/drains SD (see FIG. 24A) may constitute a plurality of multi-gate metal-oxide-semiconductor field-effect transistors (MOSFETs).

More specifically, the numerical ranges of specific components are as follows. However, the numerical ranges of specific components are examples and not limited thereto.

In some example embodiments, the first width A1B of the body SWB of the first sheet separation wall SW1 may be about or exactly 0.5 nm to about or exactly 20 nm. Also, the second width A1H of the head SWH of the first sheet separation wall SW1 may be about or exactly 3 nm to about or exactly 30 nm.

As described above, the second width A1H may be greater than the first width A1B in the first sheet separation wall SW1. In addition, the fourth width A2H may be greater than the third width A2B in the second sheet separation wall SW2. In addition, when comparing the first and second sheet separation walls SW1 and SW2 to each other, the third width A2B may be greater than the first width A1B, and the fourth width A2H may be greater than the second width A1H.

In some example embodiments, the vertical level of the uppermost end of the head SWH of the first sheet separation wall SW1 may be higher, by a first height B1, than the vertical level of the upper surface of the nanosheet NS located at the uppermost side (hereinafter, referred to as the uppermost nanosheet NS). For example, the first height B1 defined above may be about or exactly 0.5 nm to about or exactly 40 nm. In addition, the vertical level of the lowermost end of the head SWH of the first sheet separation wall SW1 may be higher, by a second height B2, than the vertical level of the upper surface of the uppermost nanosheet NS. For example, the second height B2 may be about or exactly 0.5 nm to about or exactly 20 nm.

In some example embodiments, a thickness C1 of each of the indent spacers IDT in the vertical direction (the Z direction) may be about or exactly 0.5 nm to or exactly about 7 nm. In addition, a width C2 of the indent spacer IDT in the second horizontal direction (the Y direction) may be about or exactly 0.5 nm to about or exactly 10 nm.

In some example embodiments, a vertical thickness D1 of the liner pattern LP from the lower surface to the upper surface thereof may be about or exactly 0.5 nm to about or exactly 10 nm. In addition, a width D2 of the liner pattern LP in the second horizontal direction (the Y direction) may be about or exactly 3 nm to about or exactly 30 nm.

In some example embodiments, a first height E1 of the fin-type active regions FA, for example, the vertical length from the lower surface of the fin-type active regions FA to the lower surface of the liner pattern LP, may be about or exactly 0.5 nm to about or exactly 100 nm. Also, a second height E2 of the fin-type active regions FA, for example, the vertical length from the lower surface of the liner pattern LP to the upper surface of the fin-type active regions FA, may be about or exactly 0.5 nm to about or exactly 100 nm.

In addition, although FIG. 1 illustrates that a structure including the first sheet separation wall SW1 is adjacent to a structure including the second sheet separation wall SW2, but the example embodiments are not limited thereto. That is, the integrated circuit device 10 may include at least one of the structure including the first sheet separation wall SW1 and the structure including the second sheet separation wall SW2.

Accordingly, the integrated circuit device 10 according to the inventive concepts may have the following advantages.

In some example embodiments, in the integrated circuit device 10 according to the inventive concepts, the hammer-shaped sheet separation walls SW are formed between the plurality of nanosheet stack structures NSS, and thus, the patterning margin of the gate electrodes GE may be secured. Accordingly, the difficulty of the manufacturing process may be reduced.

In some example embodiments, in the integrated circuit device 10 according to the inventive concepts, one end of the gate electrode GE facing the sheet separation wall SW is closer to the sheet separation wall SW in the second horizontal direction (the Y direction) than one end of the nanosheet NS facing the sheet separation wall SW. Accordingly, the effective channel width may be increased.

In some example embodiments, in the integrated circuit device 10 according to the inventive concepts, the nanosheet NS functioning as a channel region is spaced apart from the sheet separation wall SW by the indent spacer IDT. Accordingly, the occurrence of leakage current due to fixed charges may be prevented or reduced.

Therefore, in some example embodiments, the integrated circuit device 10 according to the inventive concepts may provide increased stable performance and improved reliability in a nanosheet field-effect transistor.

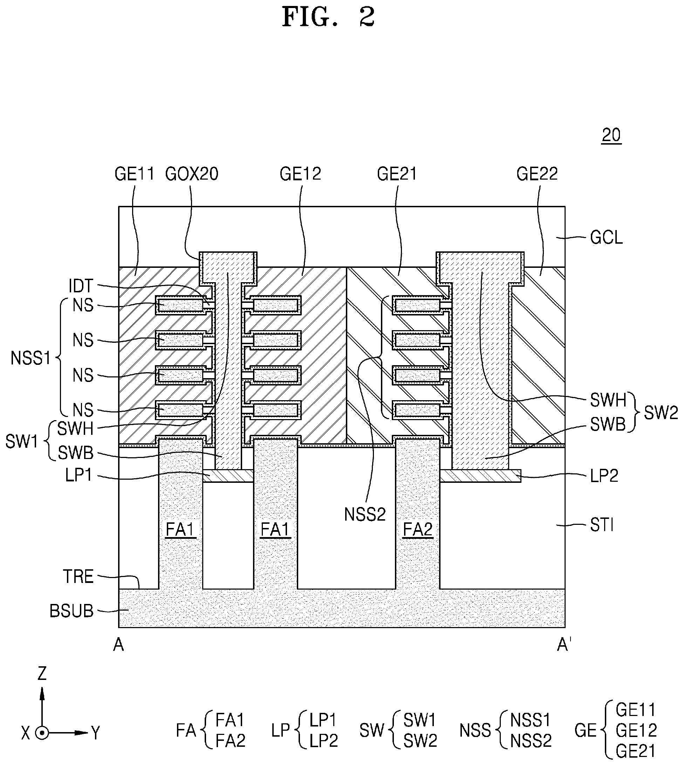

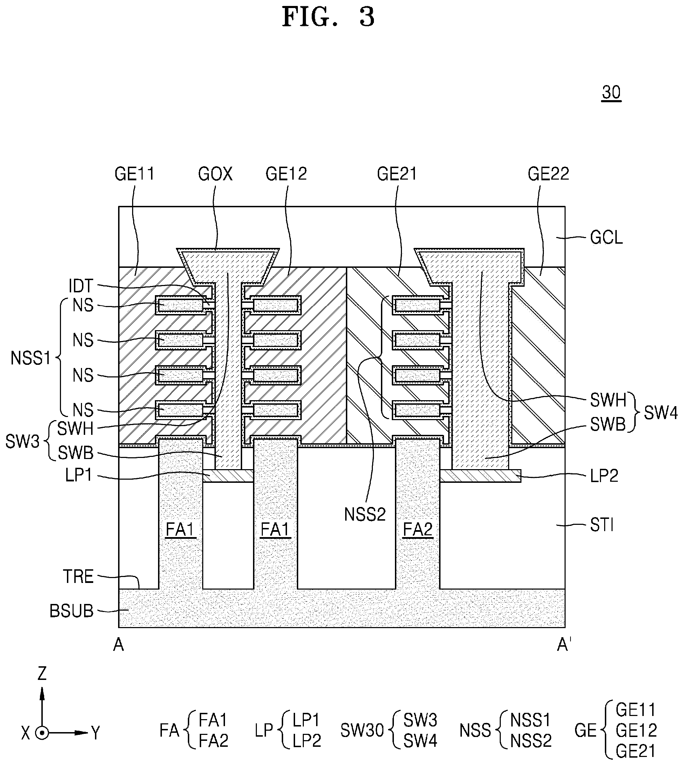

FIGS. 2 and 3 are cross-sectional views showing integrated circuit devices 20 and 30 according to some example embodiments.

Most of components constituting the integrated circuit devices 20 and 30 described below are substantially the same as or similar to those described above with reference to FIG. 1. Therefore, for convenience of description, the description focuses on differences from the integrated circuit device 10 described above.

Referring to FIG. 2, the integrated circuit device 20 according to the inventive concepts includes a field-effect transistor having a plurality of nanosheets NS which are spaced apart from each other in a vertical direction (a Z direction).

The integrated circuit device 20 according to some example embodiments may include a gate dielectric film GOX20 which is disposed between a plurality of gate electrodes GE and a plurality of nanosheet stack structures NSS including the plurality of nanosheets NS and between the plurality of gate electrodes GE and a plurality of fin-type active regions FA.

Specifically, the gate dielectric film GOX20 may conformally surround the plurality of nanosheets NS, a plurality of indent spacers IDT, and a plurality of sheet separation walls SW, but may not cover (e.g., may expose) the upper surfaces of heads SWH of the plurality of sheet separation walls SW.

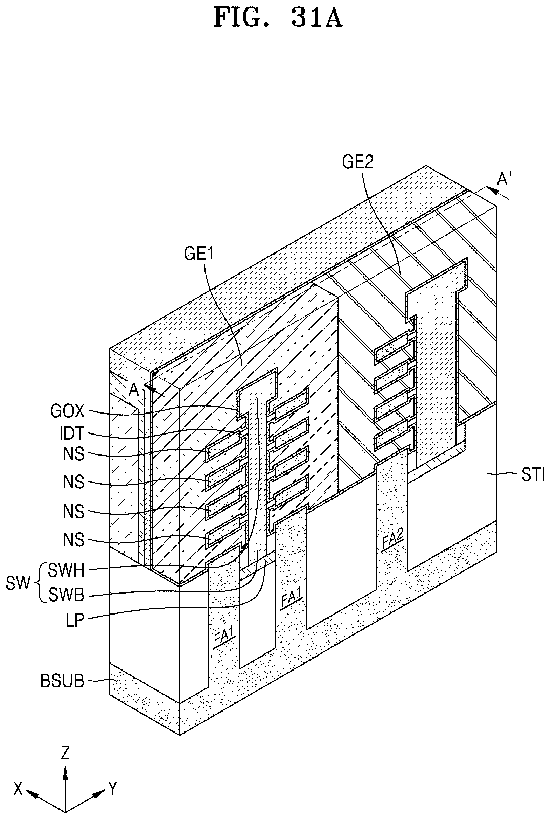

This may be a characteristic resulting from the fact that, in a patterning process of node-separating first and second gate electrode-forming layers GE1 and GE2 (see FIG. 31A) into the plurality of gate electrodes GE, the gate dielectric film GOX20 located on the upper surfaces of the heads SWH of the plurality of sheet separation walls SW are removed together.

Referring to FIG. 3, the integrated circuit device 30 according to the inventive concepts includes a field-effect transistor having a plurality of nanosheets NS which are spaced apart from each other in a vertical direction (a Z direction).

In the integrated circuit device 30 according to some example embodiments, bodies SWB of a plurality of sheet separation walls SW30 may each have a rectangular shape with longer sides in the vertical direction (the Z direction), and heads SWH of the plurality of sheet separation walls SW30 may each have an inverted trapezoidal shape in which the horizontal width in a second horizontal direction (a Y direction) decreases downward. In other words, each of the plurality of sheet separation walls SW30 may have a nail shape.

In some example embodiments, the width of a body SWB of a third sheet separation wall SW3 may be less than the width of a body SWB of a fourth sheet separation wall SW4, and the width of a head SWH of the third sheet separation wall SW3 may be less than the width of a head SWH of the fourth sheet separation wall SW4. This may be because a nanosheet stack structure NSS is not formed on one side (the far right side in the diagram) of the fourth sheet separation wall SW4, and thus, a space in which the fourth sheet separation wall SW4 may be formed is increased.

In the integrated circuit device 30 according to the inventive concepts, nail-shaped sheet separation walls SW30 are formed between a plurality of nanosheet stack structures NSS, and thus, the patterning margin of gate electrodes GE may be secured. Accordingly, the difficulty of the manufacturing process may be reduced.

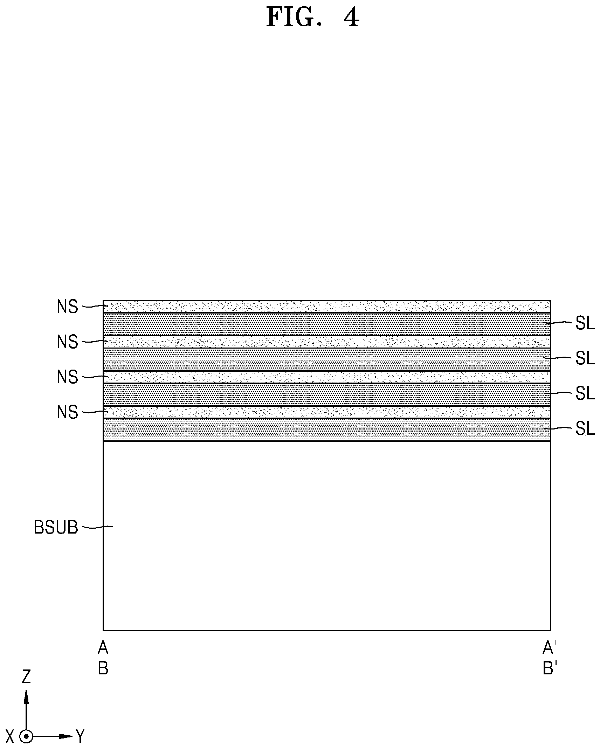

FIGS. 4 to 32B are perspective views and cross-sectional views showing a method of manufacturing an integrated circuit device in a process sequence, according to some example embodiments.

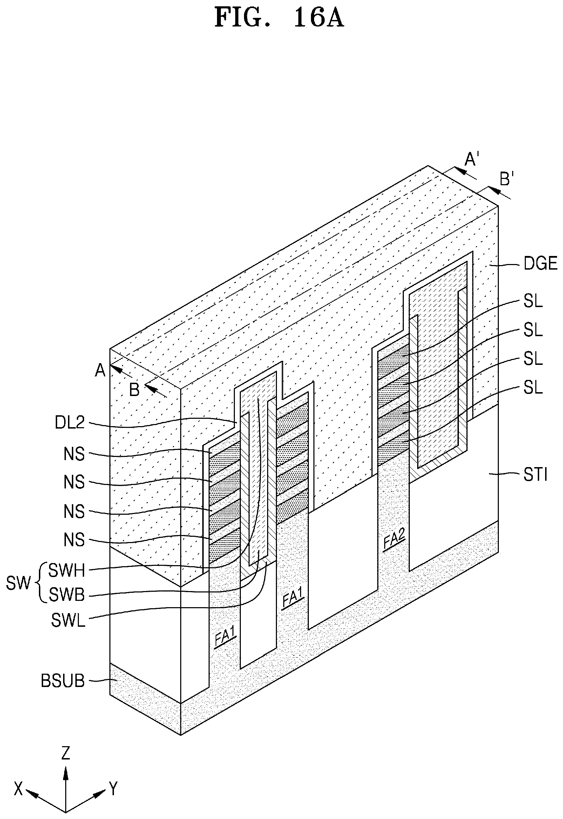

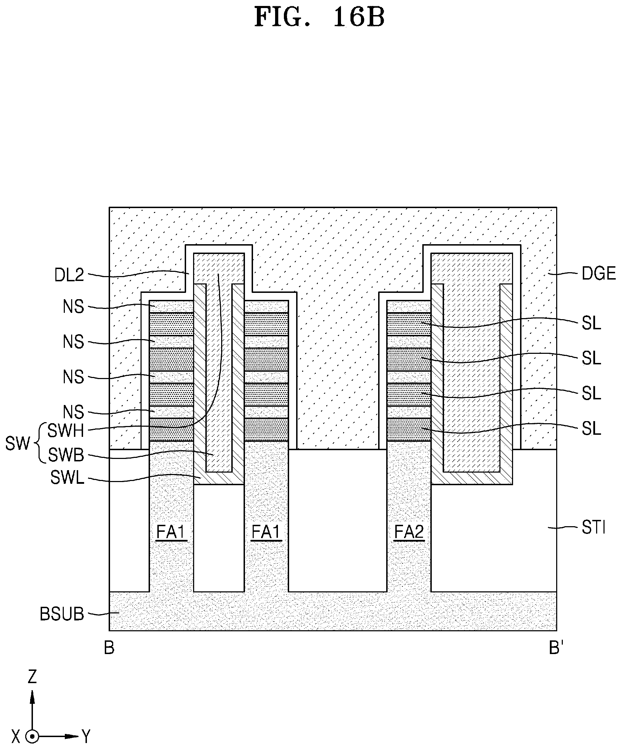

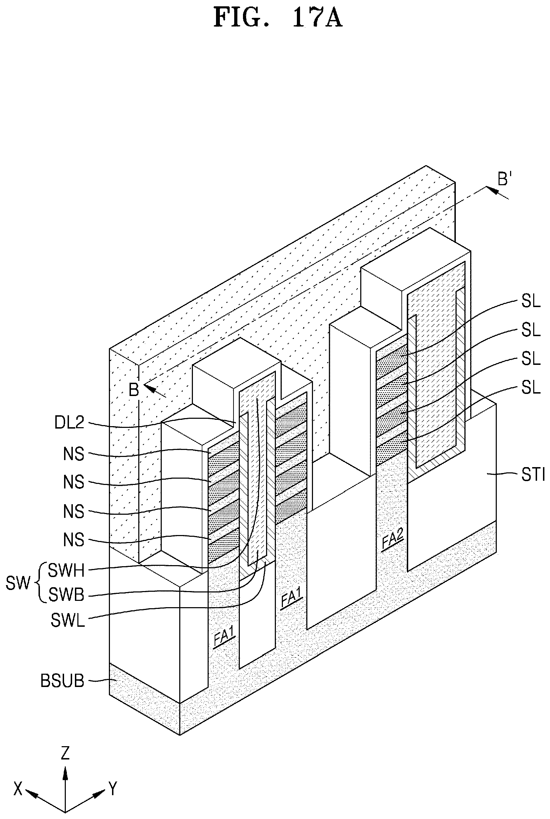

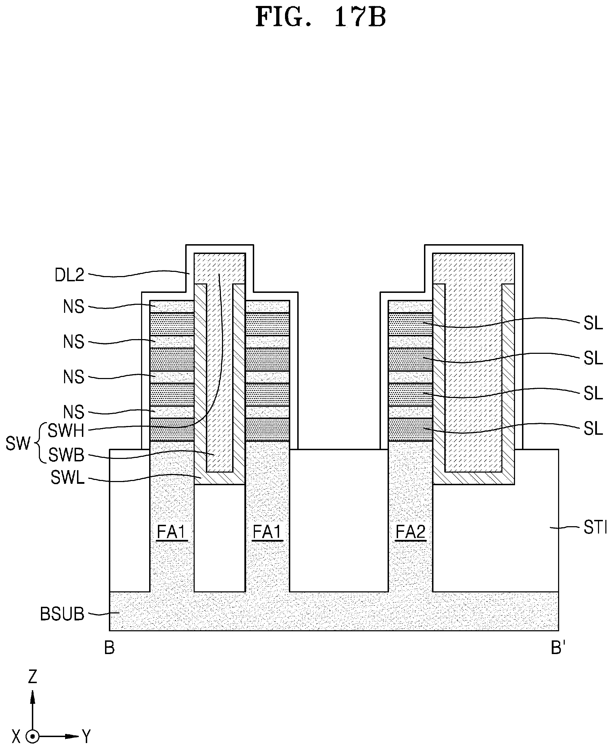

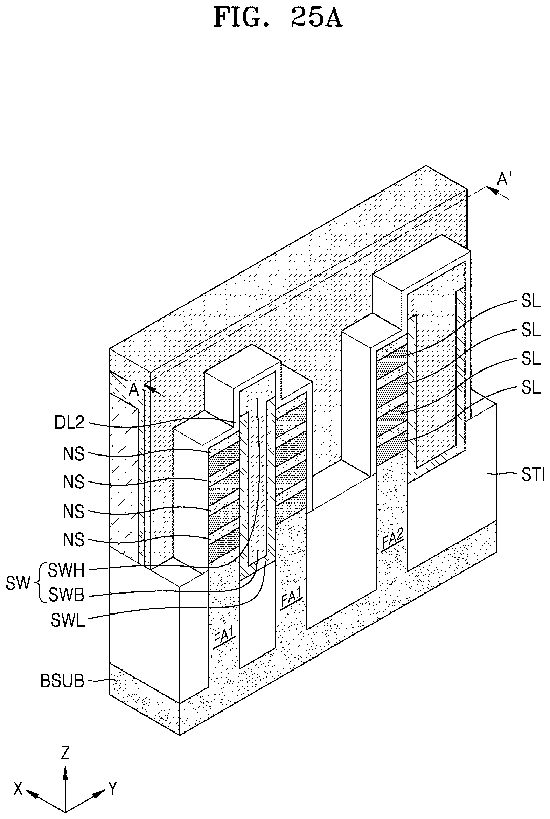

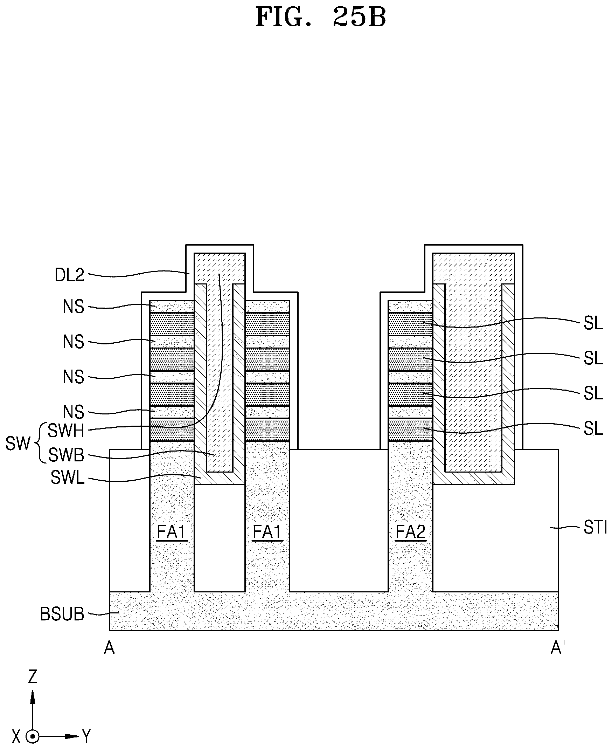

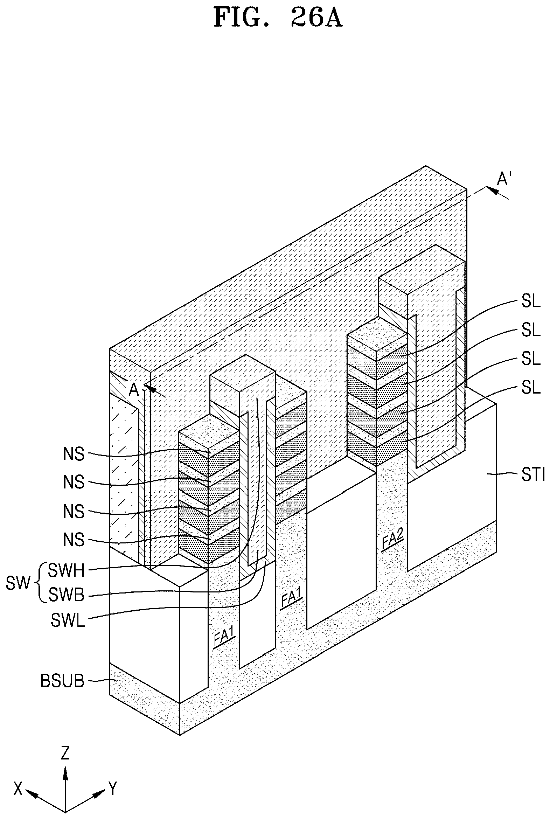

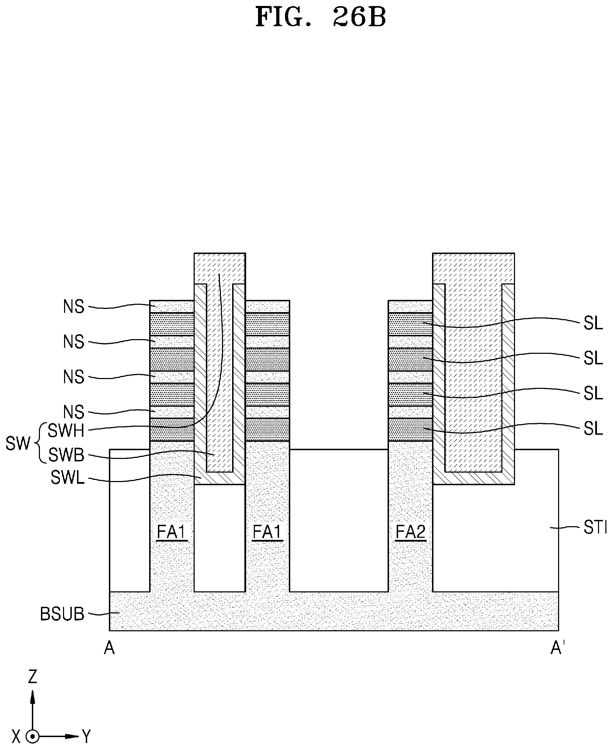

Specifically, FIGS. 4 to 15 are cross-sectional views of the integrated circuit device, corresponding to cross-sections taken along lines A-A' and B-B' of FIG. 16A. Also, FIGS. 16B, 17B, ..., and 24B are cross-sectional views of the integrated circuit device taken along lines B-B' of FIGS. 16A, 17A, ..., and 24A, respectively. Also, FIGS. 25B, 26B, ..., and 32B are cross-sectional views of the integrated circuit device taken along lines A-A' of FIGS. 25A, 26A, ..., and 32A, respectively.

Referring to FIG. 4, a plurality of sacrificial layers SL and a plurality of nanosheets NS are alternately stacked one layer at a time on a base substrate layer BSUB.

Each of the plurality of sacrificial layers SL may be arranged between the base substrate layer BSUB and a nanosheet NS located at the lowermost end (hereinafter, referred to as a lowermost nanosheet NS) among the plurality of nanosheet NS and between two nanosheets NS, which are adjacent to each other in the vertical direction (the Z direction), among the plurality of nanosheets NS. Each of the plurality of nanosheets NS and the plurality of sacrificial layers SL may extend parallel to the upper surface of the base substrate layer BSUB.

In some example embodiments, each of the plurality of nanosheets NS may have substantially the same thickness. In other embodiments, the lowermost nanosheet NS among the plurality of nanosheets NS may be thinner than the other nanosheets NS.

The base substrate layer BSUB may include semiconductor materials, such as silicon (Si) and/or germanium (Ge), and/or compound semiconductor materials, such as silicon germanium (SiGe), silicon carbide (SiC), gallium arsenide (GaAs), indium arsenide (InAs), and/or indium phosphide (InP).

In some example embodiments, the base substrate layer BSUB may include at least one of a group III-V material and a group IV material. The group III-V material may include a binary, ternary, or quaternary compound semiconductor material containing at least one group III element and at least one group V element. The base substrate layer BSUB may include a conductive region, for example, a well doped with impurities or a structure doped with impurities.

The plurality of nanosheets NS may include materials having etch characteristics identical or similar to those of the constituent materials of the base substrate layer BSUB. The plurality of sacrificial layers SL may include a material having an etch selectivity with respect to the plurality of nanosheets NS.

In some example embodiments, each of the plurality of nanosheets NS and the base substrate layer BSUB may include semiconductor materials, such as silicon (Si) and germanium (Ge). In some example embodiments, the plurality of sacrificial layers SL may include a compound semiconductor material, such as SiGe. In some example embodiments, each of the plurality of nanosheets NS, the base substrate layer BSUB, and the plurality of sacrificial layers SL may include the compound semiconductor material, such as SiGe, but the concentrations of germanium (Ge) in the plurality of nanosheets NS and the base substrate layer BSUB may be different from and the concentrations of germanium (Ge) in the plurality of sacrificial layers SL.

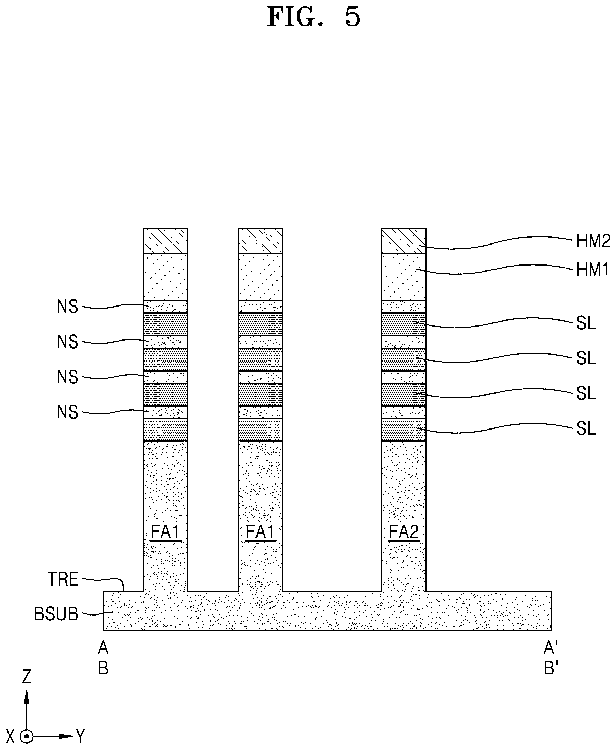

Referring to FIG. 5, first and second hard mask patterns HM1 and HM2 are formed on the stack structure of the plurality of sacrificial layers SL and the plurality of nanosheets NS. The plurality of nanosheets NS and the plurality of sacrificial layers SL are patterned by using the first and second hard mask patterns HM1 and HM2 as etch masks. The base substrate layer BSUB exposed in the patterned result is also partially removed to form a plurality of trenches TRE.

The first and second hard mask patterns HM1 and HM2 may include first hard mask patterns HM1 at a lower level and the second hard mask patterns HM2 at an upper level. The first and second hard mask patterns HM1 and HM2 may extend in a first horizontal direction (an X direction) and be spaced apart from each other in a second horizontal direction (a Y direction). The first horizontal direction (the X direction) may intersect with the second horizontal direction (the Y direction).

The plurality of trenches TRE may each extend in the first horizontal direction (the X direction). FIG. 5 illustrates that the plurality of trenches TRE have vertical sidewalls. However, in some example embodiments, the plurality of trenches TRE may each have a tapered shape in which the horizontal width decreases downward (e.g., towards the base substrate layer BSUB).

The parts of the base substrate layer BSUB protruding from the bottom surfaces of the plurality of trenches TRE may be referred to as first and second fin-type active regions FA1 and FA2.

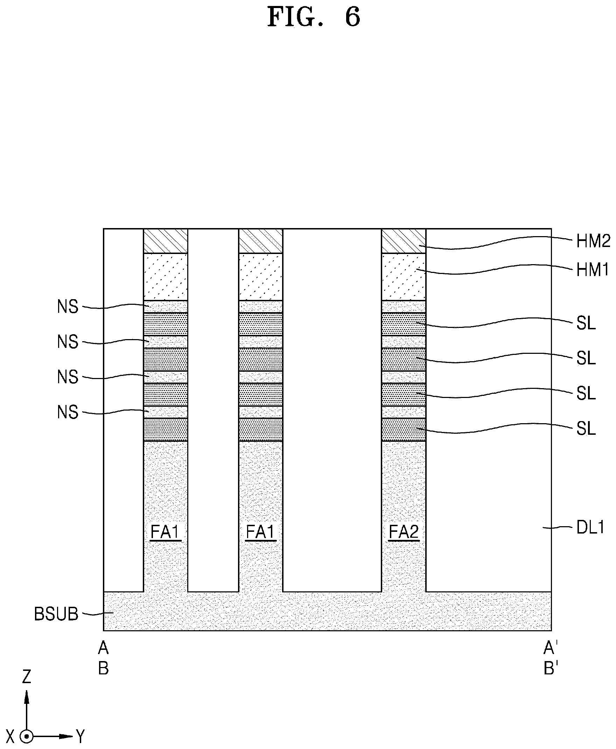

Referring to FIG. 6, a first dielectric material layer DL1 may fill all of the plurality of trenches TRE (see FIG. 5).

The first dielectric material layer DL1 may be formed to a sufficient thickness to have an upper surface at the same level as the upper surface of the second hard mask pattern HM2. The first dielectric material layer DL1 may include, for example, silicon oxide, silicon nitride, silicon oxynitride, or a combination thereof.

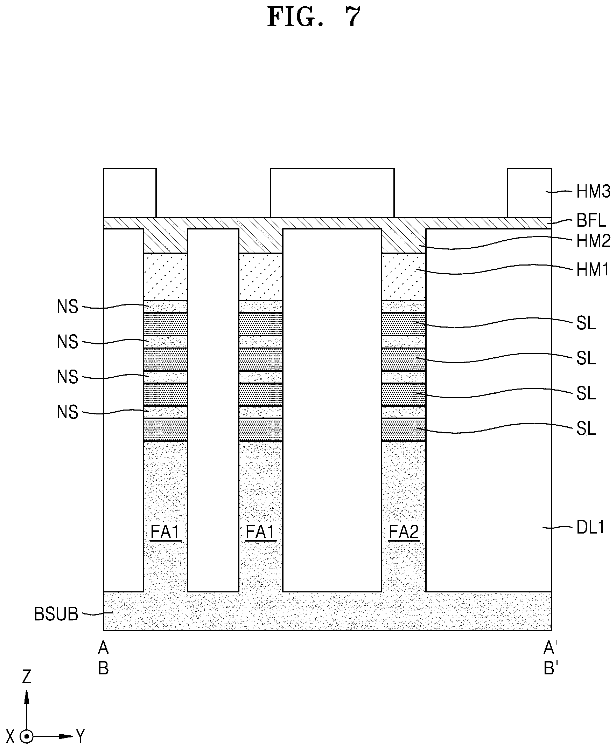

Referring to FIG. 7, after forming a buffer layer BFL on the first dielectric material layer DL1 and the second hard mask patterns HM2, third hard mask patterns HM3 may be formed on the buffer layer BFL.

The buffer layer BFL may include the same material as the material constituting the second hard mask pattern HM2. Accordingly, the buffer layer BFL and the second hard mask pattern HM2 may be formed as a single body.

The third hard mask patterns HM3 may each extend in the first horizontal direction (the X direction) on the buffer layer BFL and may be spaced apart from each other in the second horizontal direction (the Y direction). The third hard mask pattern HM3 may include a material having an etch selectivity with respect to the buffer layer BFL and the first dielectric material layer DL1.

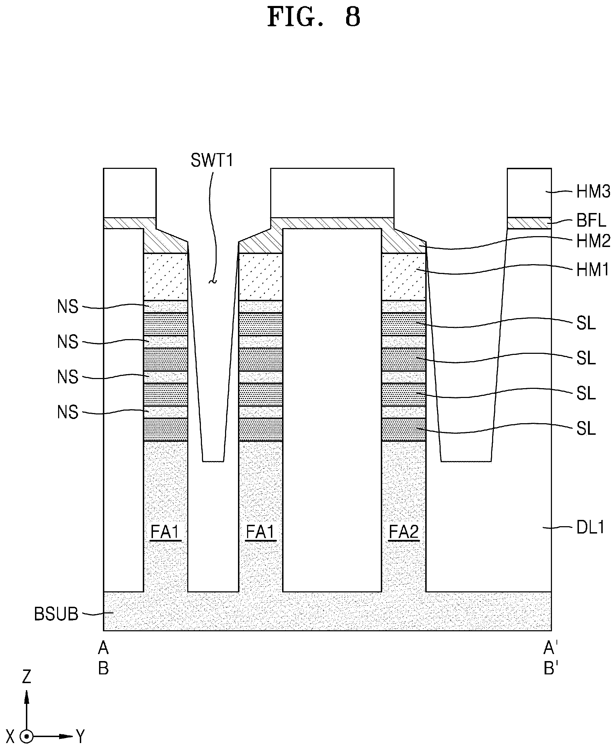

Referring to FIG. 8, the buffer layer BFL and the second hard mask pattern HM2 are patterned by using the third hard mask pattern HM3 as an etch mask. A plurality of first sheet separation trenches SWT1 are formed by partially performing a first etching process on the first dielectric material layer DL1 exposed in the patterned result.

The first etching process may include a dry etching process. Due to the characteristics of the dry etching process, the plurality of first sheet separation trenches SWT1 may each have a tapered shape in which the horizontal width decreases downward. Accordingly, the first dielectric material layer DL1 may partially remain on sidewalls of the stack structure of the plurality of sacrificial layers SL and the plurality of nanosheets NS.

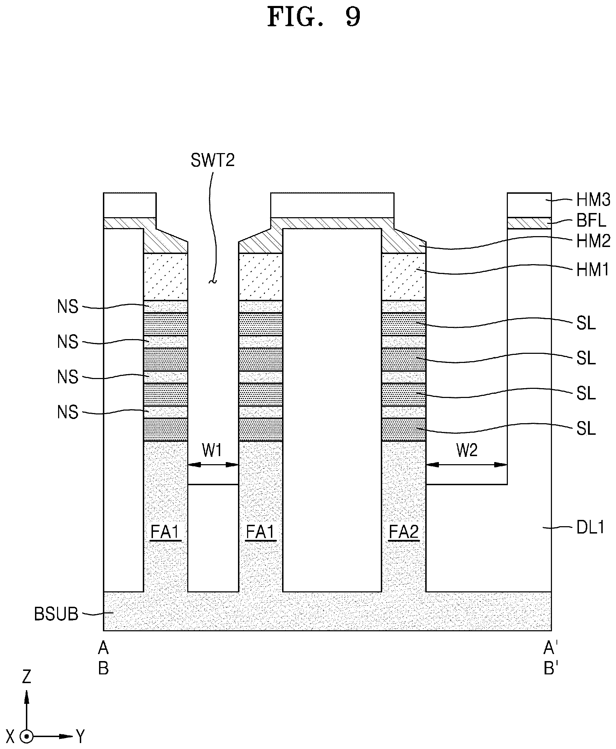

Referring to FIG. 9, a plurality of second sheet separation trenches SWT2 are formed by performing a second etching process on the plurality of first sheet separation trenches SWT1 (see FIG. 8).

The second etching process may include a wet etching process. Due to the characteristics of the wet etching process, the first dielectric material layer DL1 remaining on sidewalls of the stack structure of the plurality of sacrificial layers SL and the plurality of nanosheets NS may be removed. Therefore, the sidewalls of the stack structure of the plurality of sacrificial layers SL and the plurality of nanosheets NS may be exposed in the plurality of second sheet separation trenches SWT2.

Accordingly, a second sheet separation trench SWT2 located on the left side in the diagram may have a first trench width W1, and a second sheet separation trench SWT2 located on the right side in the diagram may have a second trench width W2. The second trench width W2 may be greater than the first trench width W1.

This may be because the plurality of nanosheets NS are not formed on one side (the far right side in the diagram) of the second sheet separation trench SWT2 located on the right side in the diagram, and thus, a space in which the second sheet separation trenches SWT2 may be formed increases.

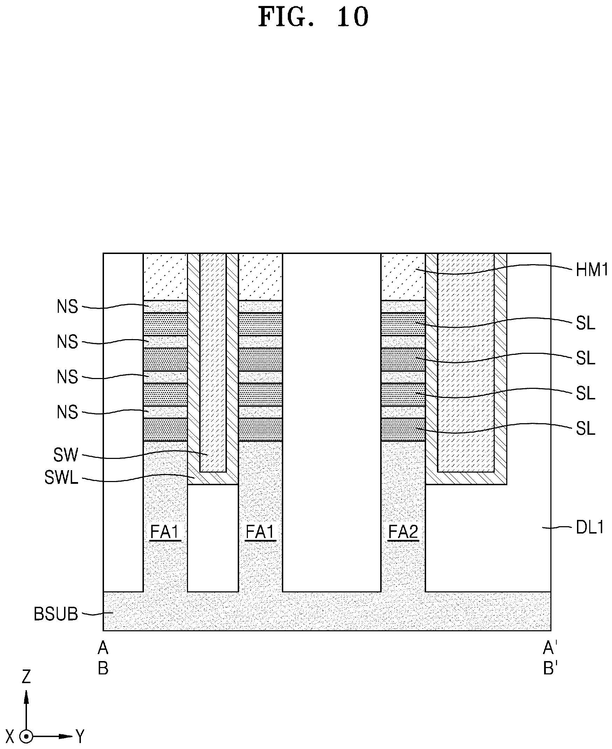

Referring to FIG. 10, the third hard mask pattern HM3 (see FIG. 9), the buffer layer BFL (see FIG. 9), and the second hard mask pattern HM2 (see FIG. 9) may be removed.

Accordingly, the upper surface of the first hard mask pattern HM1 and the uppermost surface of the first dielectric material layer DL1 may be exposed. In some example embodiments, the upper surface of the first hard mask pattern HM1 and the uppermost surface of the first dielectric material layer DL1 may have the same vertical level.

Next, a sheet separation liner SWL may be conformally formed along the inner wall of the plurality of second sheet separation trenches SWT2 (see FIG. 9). The sheet separation liner SWL may conformally cover the plurality of first hard mask patterns HM1, the plurality of nanosheets NS, the plurality of sacrificial layers SL, portions of the first and second fin-type active regions FA1 and FA2, and the exposed surface of the first dielectric material layer DL1. Also, the sheet separation liner SWL may not fill the plurality of second sheet separation trenches SWT2 (see FIG. 9).

In some example embodiments, the sheet separation liner SWL may include silicon nitride. The sheet separation liner SWL may be formed by, for example, an atomic layer deposition (ALD) process, a chemical vapor deposition (CVD) process, or a physical vapor deposition (PVD) process.

Next, a sheet separation wall SW may be formed, which covers the sheet separation liner SWL and fills each of the plurality of second sheet separation trenches SWT2 (see FIG. 9). Accordingly, the upper surface of the sheet separation wall SW, the uppermost surface of the sheet separation liner SWL, the upper surface of the first hard mask pattern HM1, and the uppermost surface of the first dielectric material layer DL1 may have the same vertical level.

The sheet separation wall SW may include a material having an etch selectivity with respect to the sheet separation liner SWL. In some example embodiments, the sheet separation wall SW may include a low-k dielectric material. The sheet separation wall SW may be formed, for example, by an ALD, CVD, or PVD process.

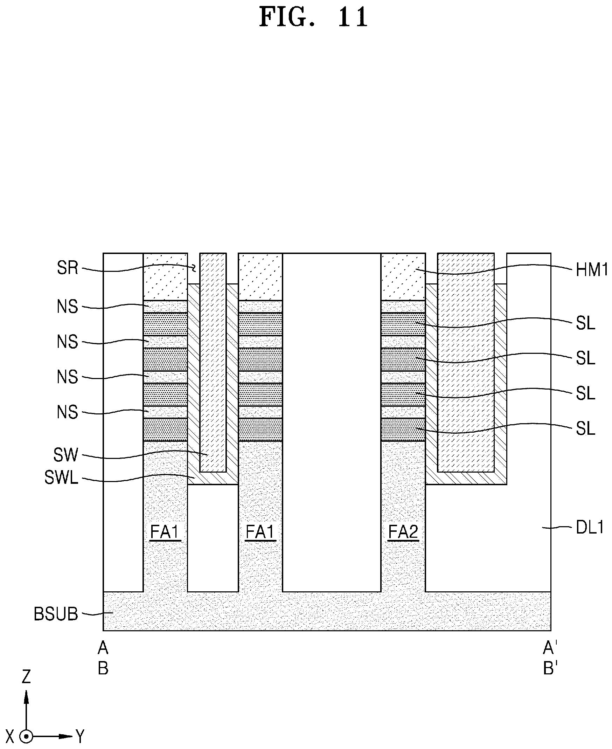

Referring to FIG. 11, an upper portion of the sheet separation liner SWL is removed partially. Accordingly, an upper recess SR may be formed, which exposes a sidewall of the first hard mask pattern HM1 and a sidewall of the sheet separation wall SW. The upper recess SR may be defined by the remaining sheet separation liner SWL, the first hard mask pattern HM1, and the sidewall of the sheet separation wall SW.

In forming the upper recess SR, only the upper portion of the sheet separation liner SWL may be removed partially, due to the difference in the etch selectivities between materials forming both the first hard mask pattern HM1 and the sheet separation wall SW and materials forming the sheet separation liner SWL.

In some example embodiments, the vertical level of the bottom surface of the upper recess SR may be higher than the vertical level of the lower surface of the first hard mask pattern HM1.

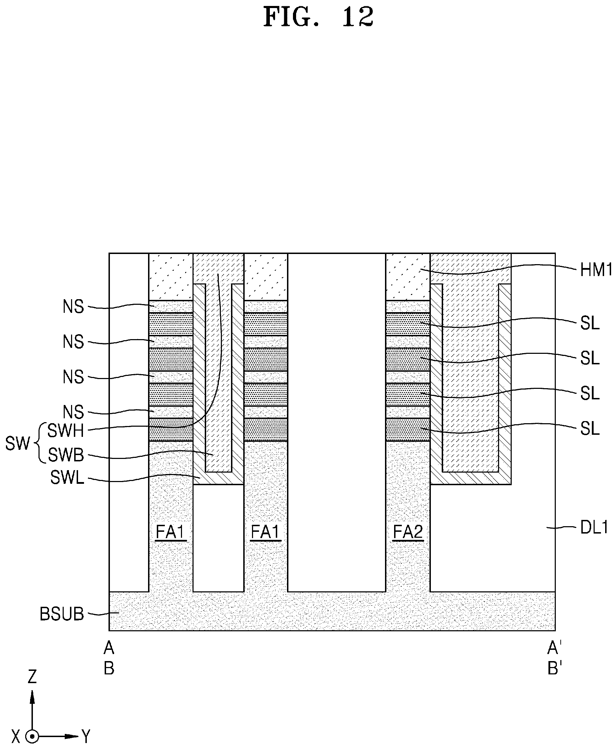

Referring to FIG. 12, a head SWH is formed by filling the upper recess SR (see FIG. 11). Accordingly, a hammer-shaped sheet separation wall SW may be formed in which the head SWH is integrated with a body SWB.

Accordingly, the sheet separation wall SW may be changed into a shape that includes the body SWB having a first width and the head SWH having a second width greater than the first width. That is, the sheet separation liner SWL may be disposed only on the regions that surround the sidewall and lower surface of the body SWB of the sheet separation wall SW.

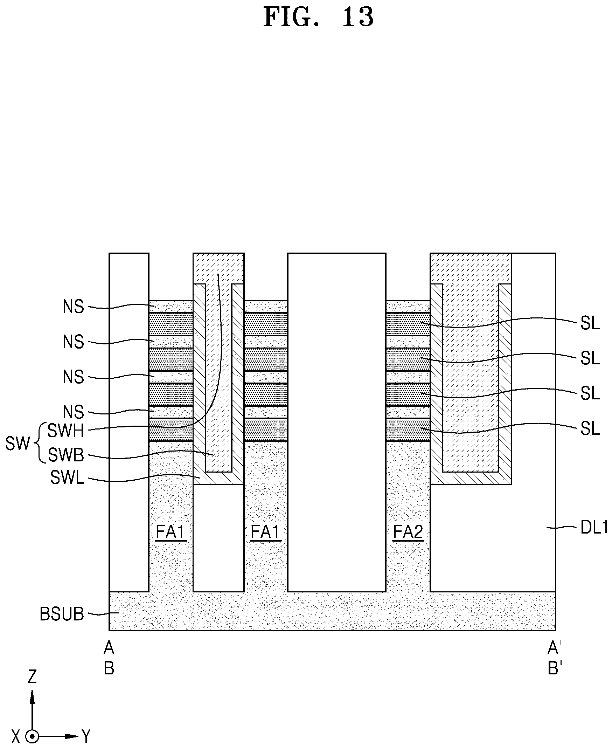

Referring to FIG. 13, the first hard mask pattern HM1 (see FIG. 12) may be removed.

Accordingly, the upper surface of the uppermost nanosheet NS among the plurality of nanosheets NS, the sidewall of the first dielectric material layer DL1, the upper sidewall of the sheet separation liner SWL, and the sidewall of the head SWH of the sheet separation wall SW may be exposed.

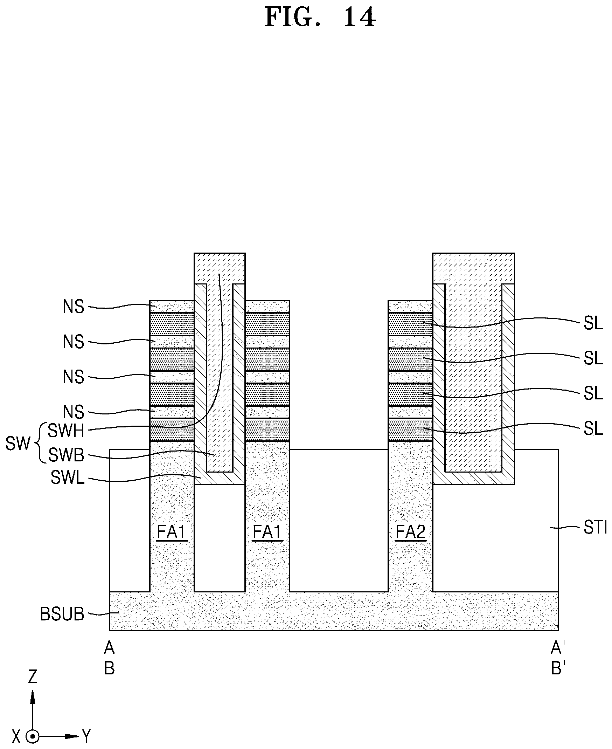

Referring to FIG. 14, an upper portion of the first dielectric material layer DL1 (see FIG. 13) is removed, and the remaining portion of the first dielectric material layer DL1 (see FIG. 13) may be formed as a trench isolation STI.

In some example embodiments, the vertical level of the upper surface of the trench isolation STI may be lower than the vertical level of the upper surfaces of the first and second fin-type active regions FA1 and FA2. For example, the first and second fin-type active regions FA1 and FA2 may correspond to portions of the base substrate layer BSUB which are defined by the trench isolation STI.

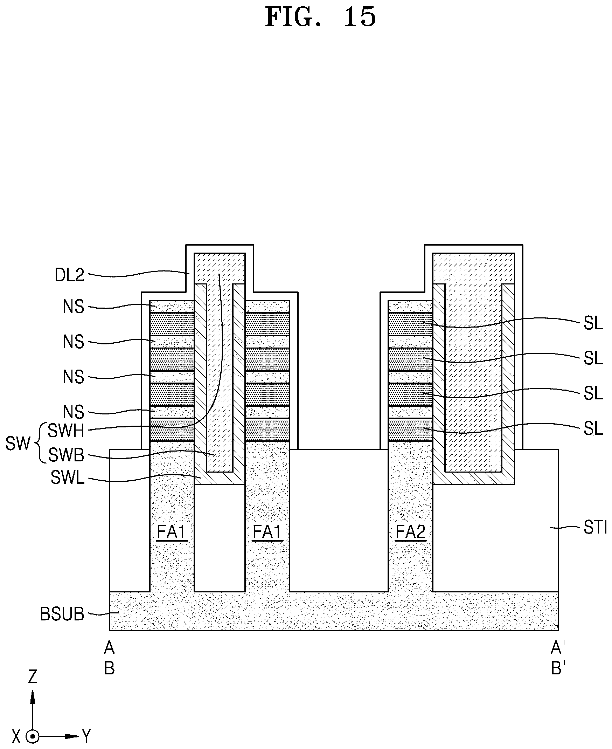

Referring to FIG. 15, a second dielectric material layer DL2 is formed, which conformally covers the trench isolation STI, the sidewalls of the first and second fin-type active regions FA1 and FA2, the plurality of sacrificial layers SL, the plurality of nanosheets NS, the sidewall of the sheet separation liner SWL, and the head SWH of the sheet separation wall SW.

The second dielectric material layer DL2 may include, for example, the same material as the trench isolation STI. In some example embodiments, the second dielectric material layer DL2 may serve as a dummy gate dielectric film.

Referring to FIGS. 16A and 16B together, a dummy gate electrode DGE is formed, which covers the second dielectric material layer DL2 and the trench isolation STI.

In some example embodiments, the dummy gate electrode DGE may include polysilicon. That is, the second dielectric material layer DL2 as a dummy gate dielectric film may be completely covered by the dummy gate electrode DGE.

Referring to FIGS. 17A and 17B together, the dummy gate electrode DGE is removed from a source/drain region (a region of line B-B') of the dummy gate electrode DGE.

The dummy gate electrode DGE is removed, and the second dielectric material layer DL2 and the trench isolation STI are exposed in the source/drain region (the region of line B-B'). On the other hand, since the dummy gate electrode DGE is not removed in a gate region (a region of line A-A'), the second dielectric material layer DL2 and the trench isolation STI are not exposed in the gate region (the region of line A-A').

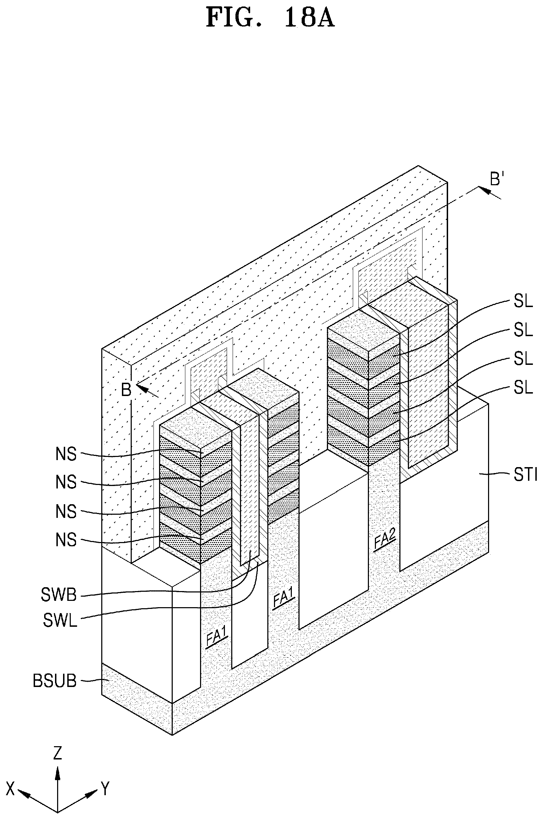

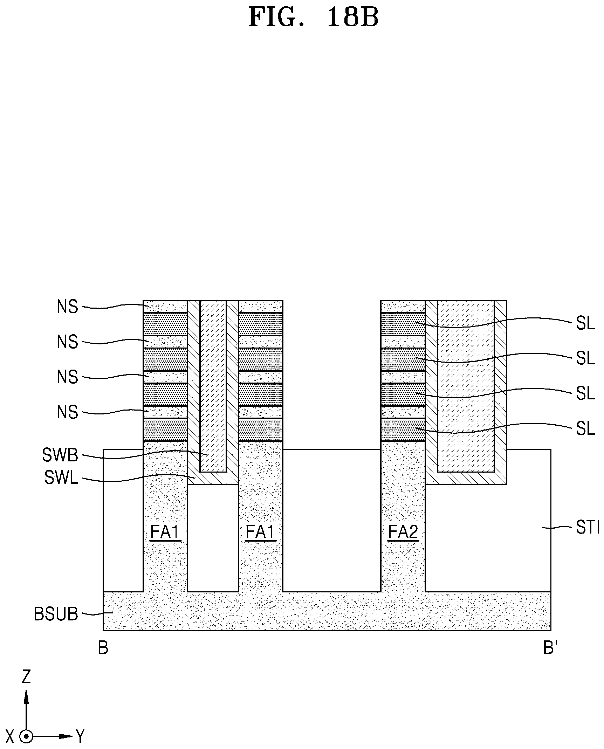

Referring to FIGS. 18A and 18B together, the second dielectric material layer DL2 exposed in the source/drain region (the region of line B-B') is removed.

As the exposed second dielectric material layer DL2 is removed, the plurality of sacrificial layers SL, the plurality of nanosheets NS, the upper portion of the sheet separation liner SWL, and the head SWH of the sheet separation wall SW are exposed.

Next, the upper portion of the exposed sheet separation liner SWL and the head SWH of the sheet separation wall SW are removed. Accordingly, the uppermost surface of the plurality of nanosheets NS, the uppermost surface of the sheet separation liner SWL, and the upper surface of the sheet separation wall SW may have the same or substantially the same vertical level.

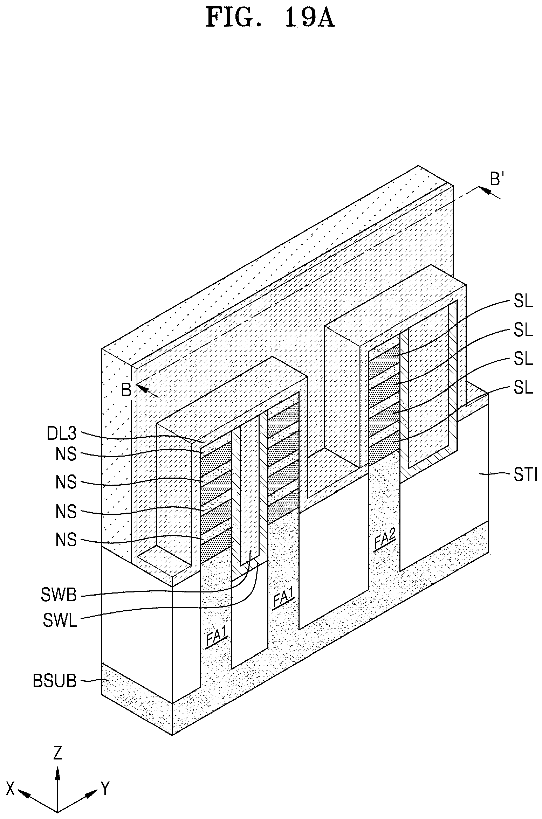

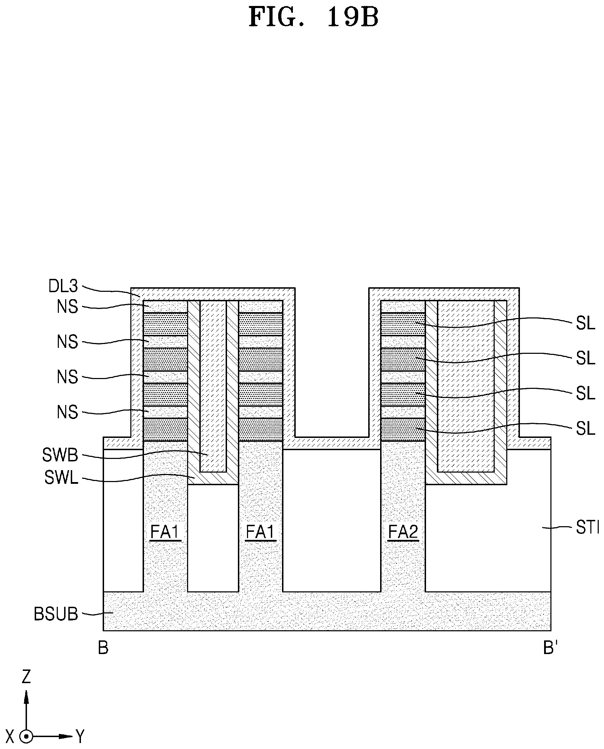

Referring to FIGS. 19A and 19B together, a third dielectric material layer DL3 may be formed, which conformally covers the trench isolation STI, the plurality of sacrificial layers SL, the plurality of nanosheets NS, the sheet separation liner SWL, and the sheet separation wall SW.

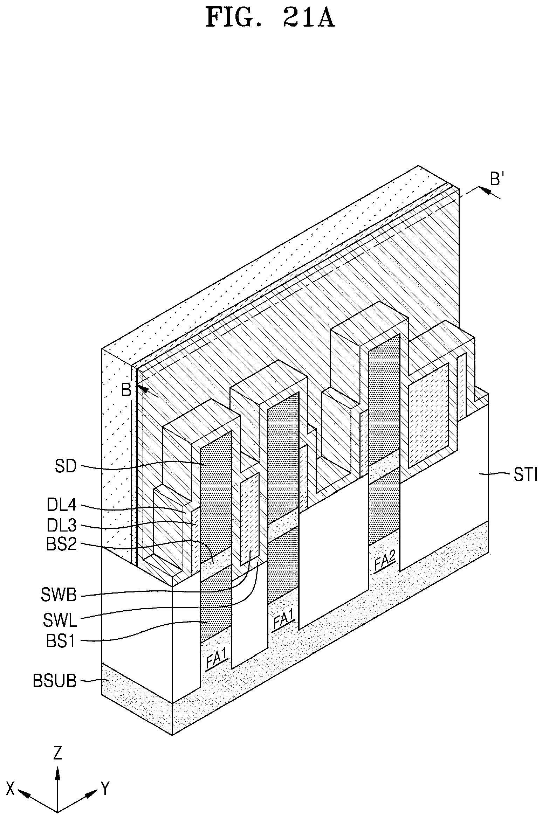

In some example embodiments, the third dielectric material layer DL3 may include silicon nitride, silicon carbide, or silicon carbonitride. The third dielectric material layer DL3 may be formed to a certain thickness because a spacer is formed on a sidewall of a source/drain SD (see FIG. 21A) described below.

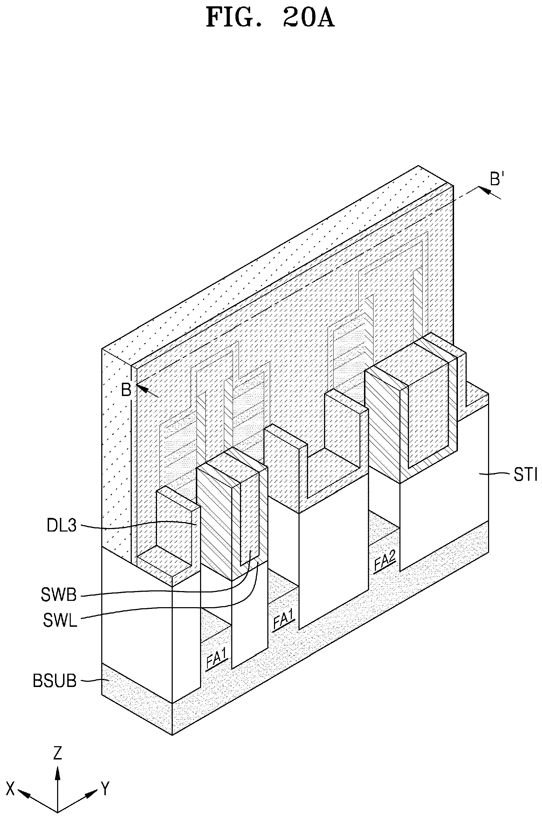

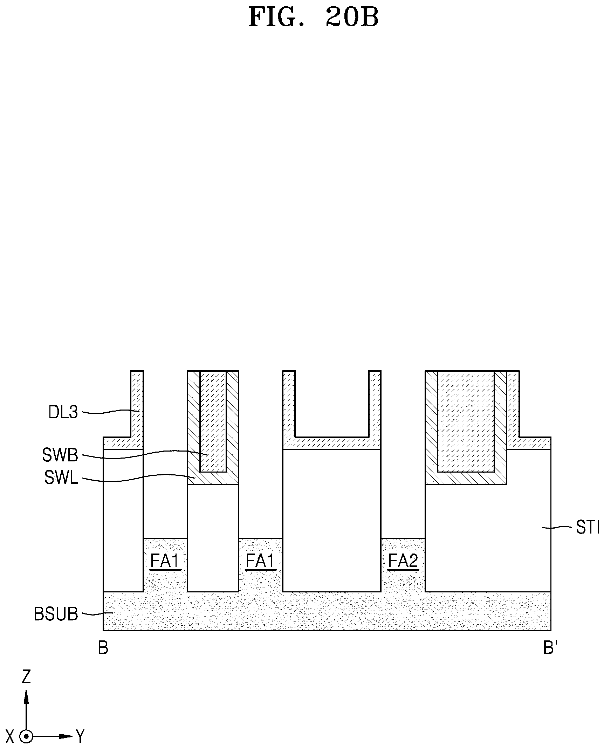

Referring to FIGS. 20A and 20B together, the third dielectric material layer DL3 may be patterned, and the plurality of exposed sacrificial layers SL, the plurality of exposed nanosheets NS, a portion of the exposed sheet separation liner SWL, a portion of the exposed sheet separation wall SW, and portions of the exposed first and second fin-type active regions FA1 and FA2 may be removed.

Accordingly, the plurality of sacrificial layers SL and the plurality of nanosheets NS may be completely removed in the source/drain region (the region of line B-B'). Also, the vertical levels of the upper surface of the third dielectric material layer DL3, the upper surface of the sheet separation liner SWL, the upper surface of the sheet separation wall SW, and the upper surfaces of the first and second fin-type active regions FA1 and FA2 may all be lowered.

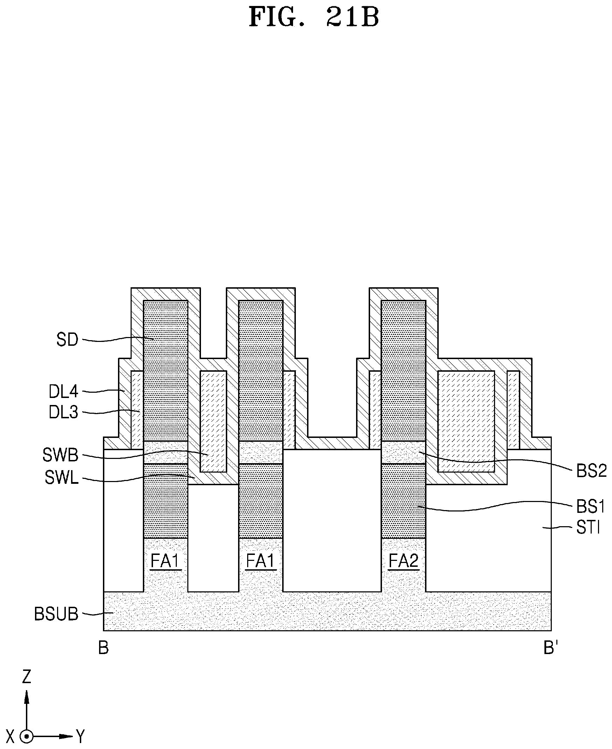

Referring to FIGS. 21A and 21B together, a first backside electrode-forming layer BS1, a second backside electrode-forming layer BS2, and a source/drain SD may be sequentially formed on each of the upper surfaces of the first and second fin-type active regions FA1 and FA2.

The plurality of sources/drains SD may include an embedded SiGe structure including a plurality of epitaxially grown SiGe layers, an epitaxially grown silicon (Si) layer, or an epitaxially grown SiC layer.

In some example embodiments, some of the plurality of sources/drains SD may contain impurities of a different conductive type than the other sources/drains SD. The plurality of nanosheets NS in contact with some of the plurality of sources/drains SD may contain impurities of a different conductivity type than the plurality of nanosheets NS in contact with the others of the plurality of sources/drains SD.

Accordingly, for example, an n-type metal-oxide semiconductor (NMOS) transistor may be formed in a region in which some of the plurality of sources/drains SD are formed, and a p-type metal-oxide semiconductor (PMOS) transistor may be formed in a region in which the other sources/drains SD are formed.

The first backside electrode-forming layer BS1 may include the same material as the plurality of sources/drains SD. For example, the SiGe layer in the first backside electrode-forming layer BS1 may have the same or substantially the same germanium (Ge) concentration as the SiGe layer in the plurality of sources/drains SD.

The first backside electrode-forming layer BS1 may include a different material from the second backside electrode-forming layer BS2. For example, the SiGe layer in the first backside electrode-forming layer BS1 may have a different germanium (Ge) concentration from the SiGe layer in the second backside electrode-forming layer BS2.

Next, a fourth dielectric material layer DL4 may be formed, which covers the third dielectric material layer DL3, the sheet separation liner SWL, the sheet separation wall SW, the first and second fin-type active regions FA1 and FA2, and the source/drain SD. The fourth dielectric material layer DL4 may include, for example, the same material as the sheet separation liner SWL.

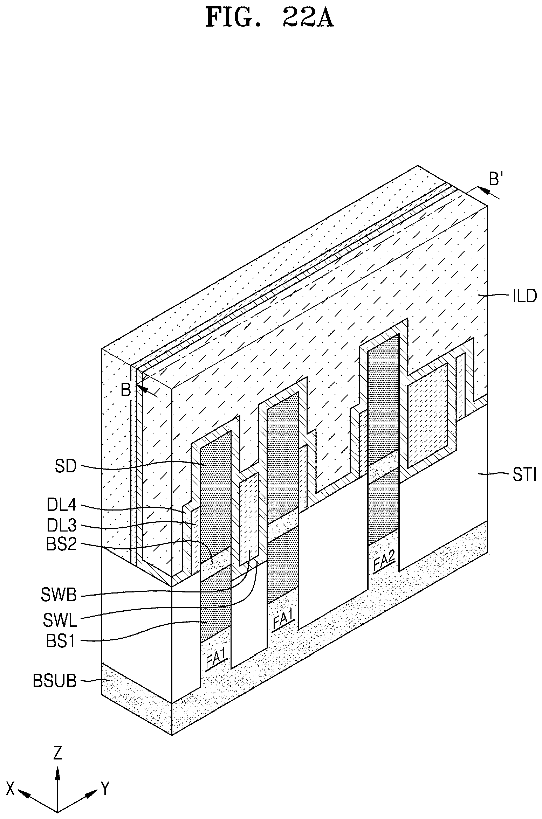

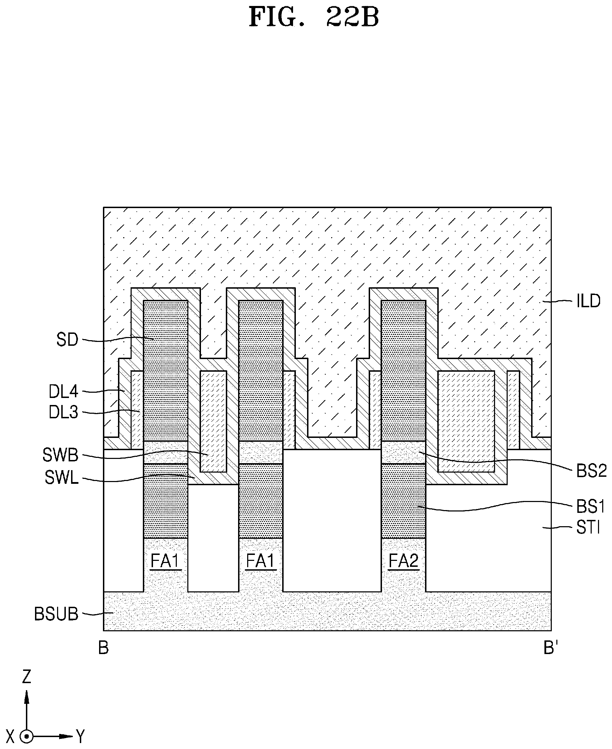

Referring to FIGS. 22A and 22B together, an interlayer dielectric film ILD covering the fourth dielectric material layer DL4 may be formed.

The interlayer dielectric film ILD may include, for example, silicon oxide or a dielectric material having a lower dielectric constant than the silicon oxide. In some example embodiments, the interlayer dielectric film ILD may include a tetraethyl orthosilicate (TEOS) film and/or an ultra low-K (ULK) film having an ultra low dielectric constant K of about or exactly 2.2 to about or exactly 2.4. The ULK film may include, for example, a SiOC film and/or a SiCOH film.

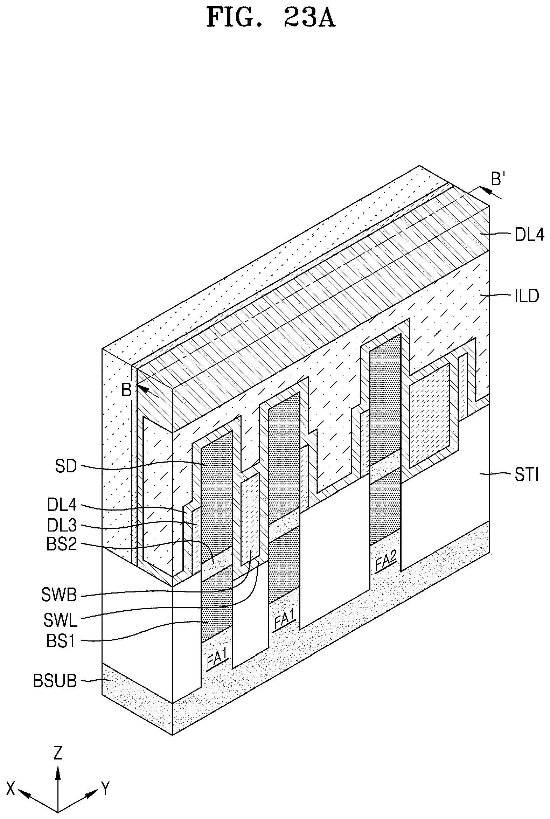

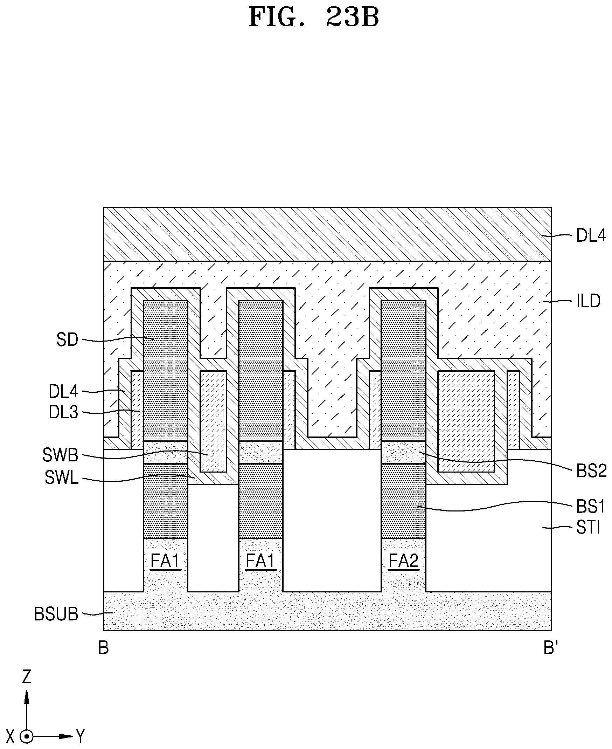

Referring to FIGS. 23A and 23B together, the upper portion of the interlayer dielectric film ILD is partially removed, and a region above the removed interlayer dielectric film ILD may be filled with the same material as the fourth dielectric material layer DL4.

Accordingly, the fourth dielectric material layer DL4 may have a shape surrounding the interlayer dielectric film ILD. In some example embodiments, the fourth dielectric material layer DL4 may include silicon nitride. The fourth dielectric material layer DL4 added may be formed to be integral to the lower fourth dielectric material layer DL4 or may have an interface therebetween.

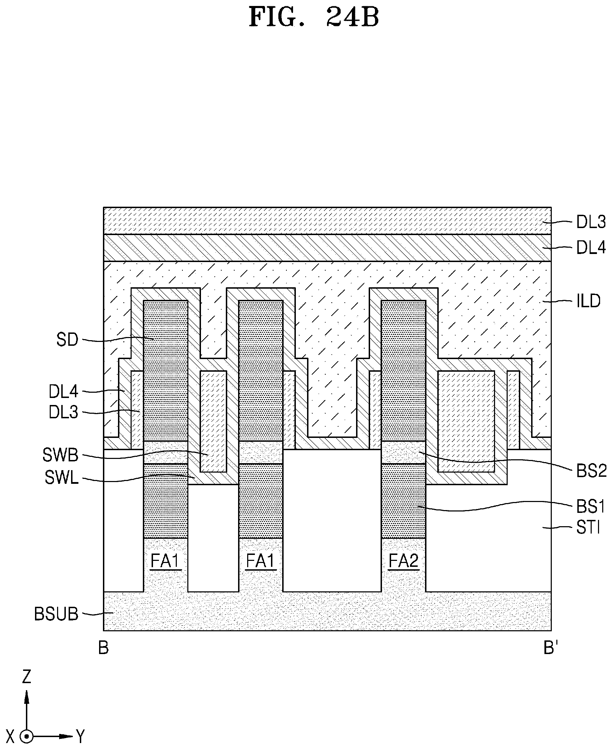

Referring to FIGS. 24A and 24B together, the upper portion of the fourth dielectric material layer DL4 is partially removed, and a region above the removed fourth dielectric material layer DL4 may be filled with the same material as the third dielectric material layer DL3.

Accordingly, the third dielectric material layer DL3 may have a shape surrounding the fourth dielectric material layer DL4. In some example embodiments, the third dielectric material layer DL3 may include silicon nitride, silicon carbide, or silicon carbonitride. The third dielectric material layer DL3 added may be formed to be integral to the lower third dielectric material layer DL3 or may have an interface therebetween.

Referring to FIGS. 25A and 25B together, the dummy gate electrode DGE is removed from the gate region (the region of line A-A') of the dummy gate electrode DGE.

The dummy gate electrode DGE is removed, and the second dielectric material layer DL2 and the trench isolation STI are exposed in the gate region (the region of line A-A'). On the other hand, the second dielectric material layer DL2 and the trench isolation STI are not exposed in the source/drain region (the region of line B-B') due to the interlayer dielectric film ILD, the fourth dielectric material layer DL4, and the third dielectric material layer DL3 which were previously formed.

Referring to FIGS. 26A and 26B together, the second dielectric material layer DL2 exposed in the gate region (the region of line A-A') is removed.

As the exposed second dielectric material layer DL2 is removed, the plurality of sacrificial layers SL, the plurality of nanosheets NS, the sidewall of the sheet separation liner SWL, and the head SWH of the sheet separation wall SW are exposed in the gate region (the region of line A-A').

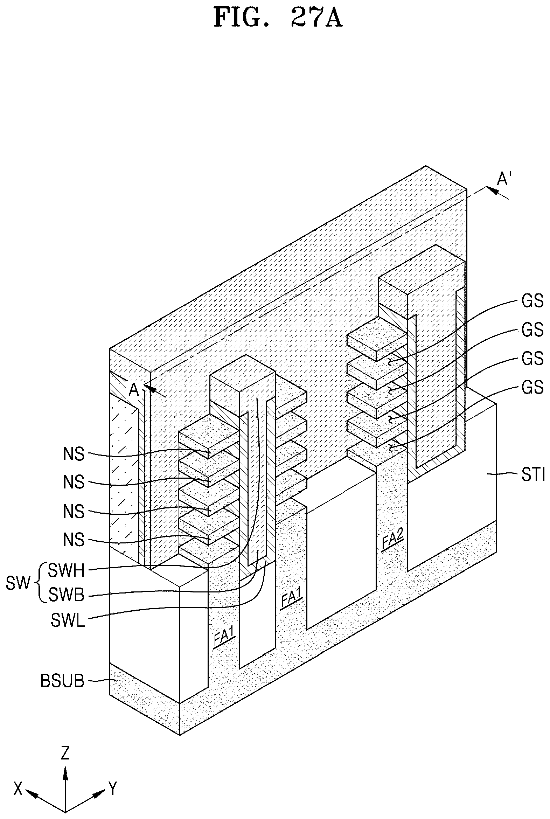

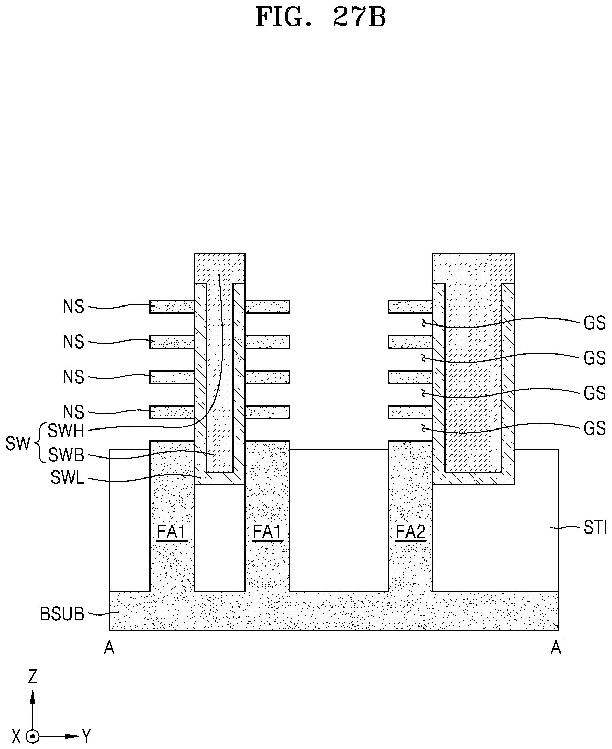

Referring to FIGS. 27A and 27B together, the plurality of sacrificial layers SL (see FIG. 26A) may be removed.

Accordingly, a plurality of gate spaces GS may be formed between a fin-type active region FA and the lowermost nanosheet NS among the plurality of nanosheets NS and between two nanosheets NS adjacent to each other in the vertical direction (the Z direction) among the plurality of nanosheets NS.

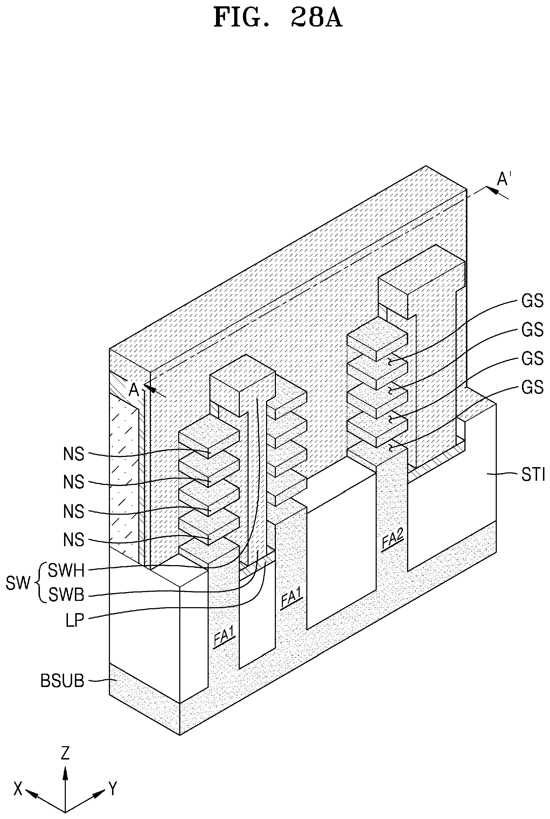

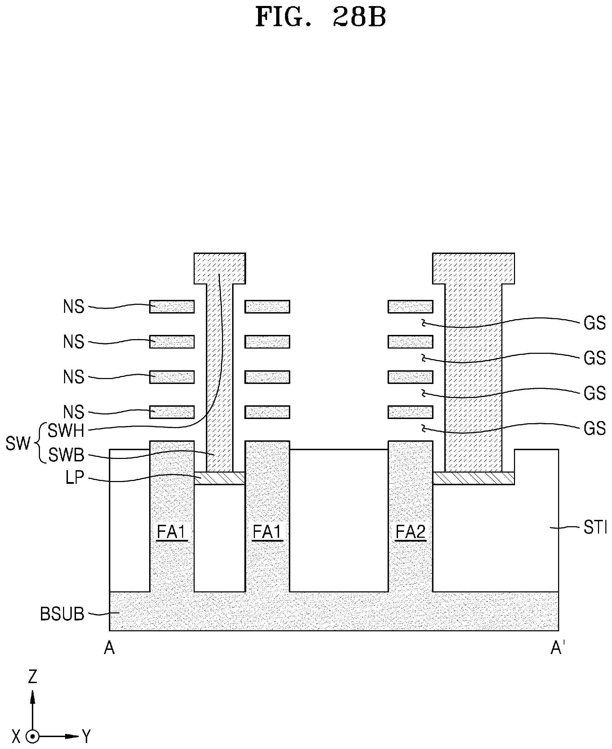

Referring to FIGS. 28A and 28B together, the sheet separation liner SWL (see FIG. 27A) positioned on the sidewall of the body SWB of the sheet separation wall SW may be partially removed through the plurality of gate spaces GS.

Accordingly, the body SWB of the sheet separation wall SW within the plurality of gate spaces GS may be exposed. However, the bottom portion of the sheet separation liner SWL (see FIG. 27A) that remains without being removed may form a liner pattern LP.

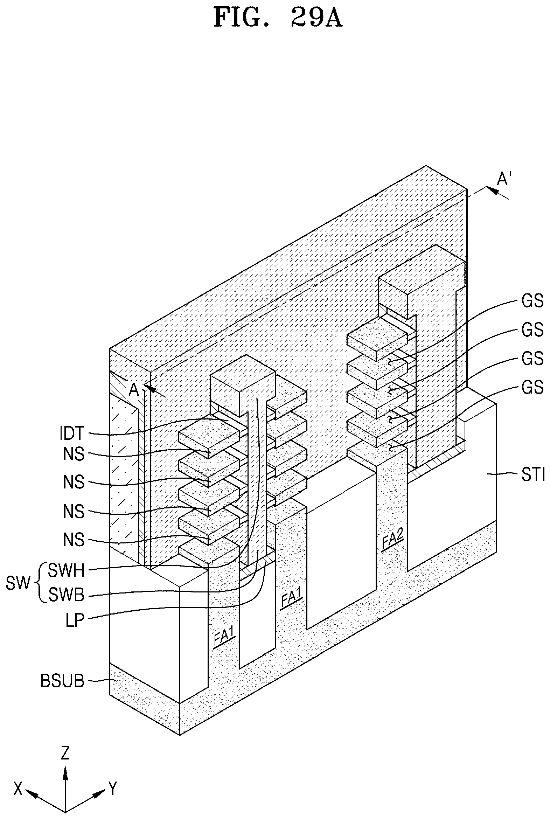

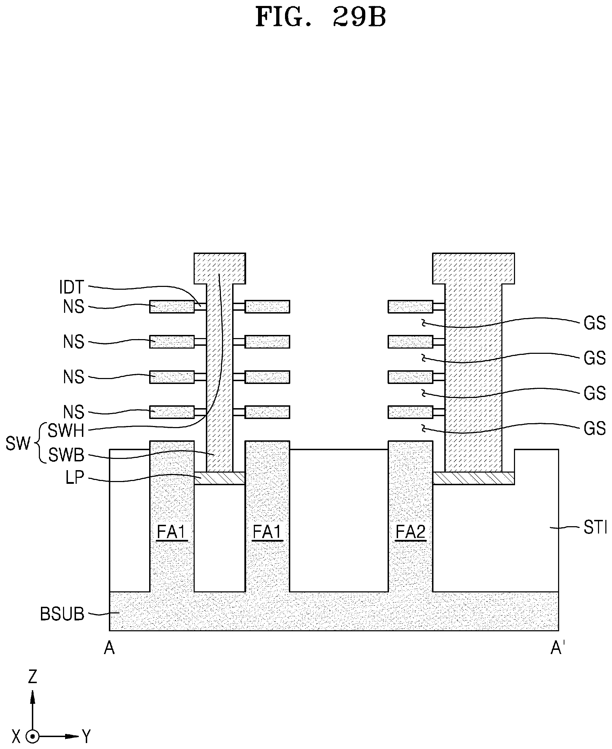

Referring to FIGS. 29A and 29B together, a plurality of indent spacers IDT may be formed between the plurality of nanosheets NS and the sheet separation wall SW.

Accordingly, the plurality of indent spacers IDT are positioned in the second horizontal direction (the Y direction) from the sidewall of the body SWB of the sheet separation wall SW to the sidewall of the plurality of nanosheets NS facing the body SWB and are spaced apart from each other in the vertical direction (the Z direction). Therefore, the sheet separation wall SW may have an indent shape or T-shape.

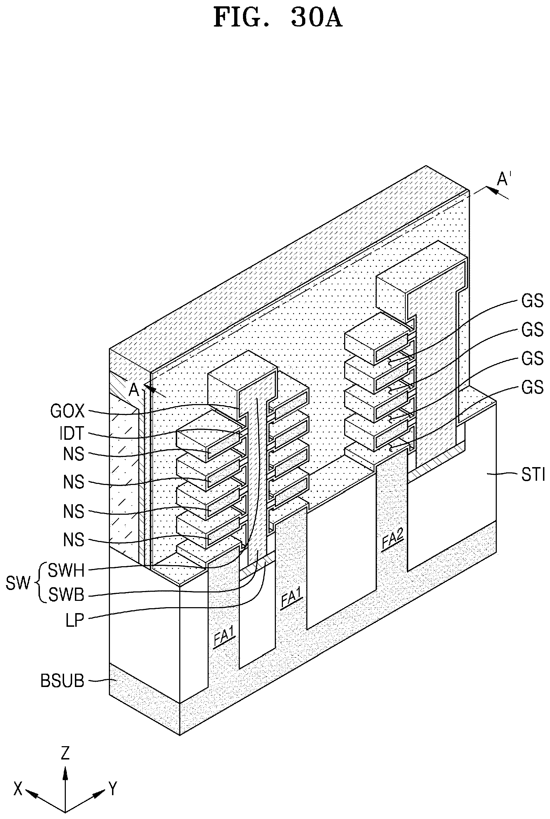

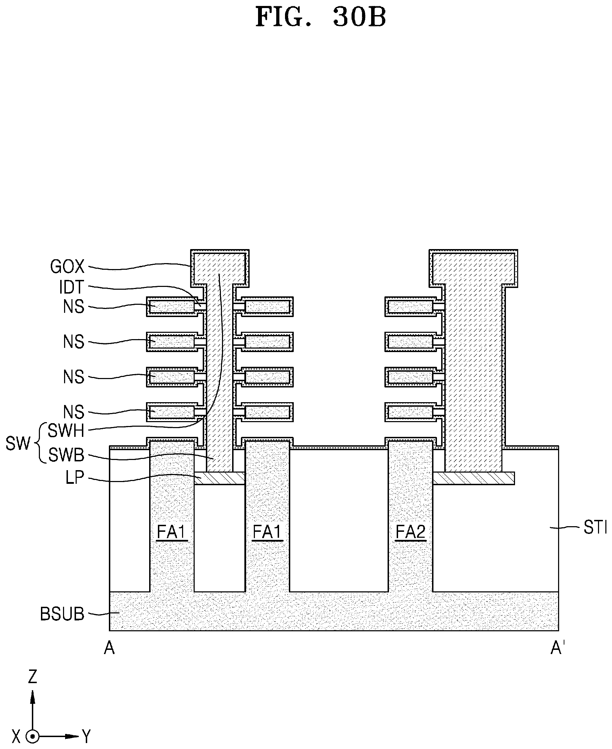

Referring to FIGS. 30A and 30B together, after the formation of the plurality of indent spacers IDT, a gate dielectric film GOX may be formed that conformally covers the exposed surfaces described above.

The gate dielectric film GOX may include silicon oxide, a high-k dielectric film, or a combination thereof. The high-k dielectric film may include a material having a higher dielectric constant than silicon oxide. For example, the high-k dielectric film may have a dielectric constant of about or exactly 10 to about or exactly 25. In some example embodiments, the high-k dielectric film may include metal oxide or metal oxynitride. For example, the gate dielectric film GOX may include HfO₂, Al₂O₃, HfAlO₃, Ta₂O₃, and/or TiO₂.

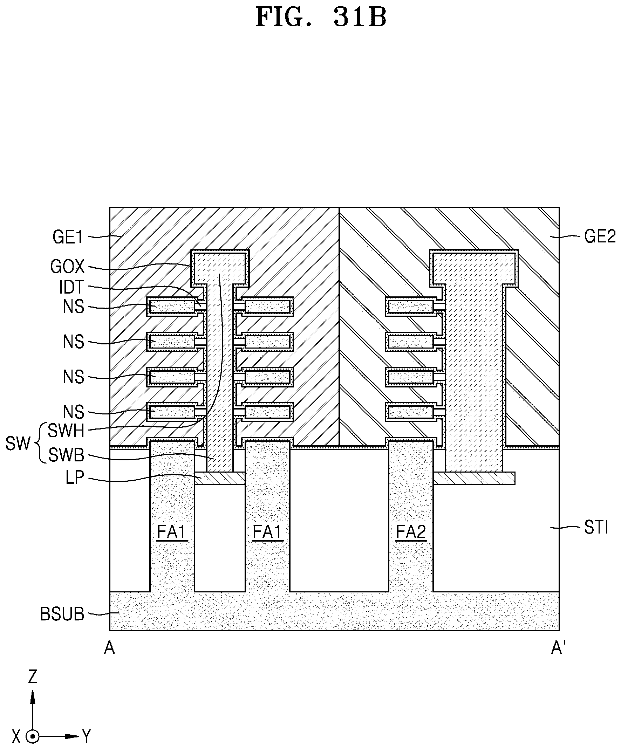

Referring to FIGS. 31A and 31B together, first and second gate electrode-forming layers GE1 and GE2 covering the exposed surfaces may be formed after forming the gate dielectric film GOX.

The first and second gate electrode-forming layers GE1 and GE2 may be formed by a replacement metal gate process. The first and second gate electrode-forming layers GE1 and GE2 may include the first gate electrode-forming layer GE1 and the second gate electrode-forming layer GE2.

In some example embodiments, the first and second gate electrode-forming layers GE1 and GE2 may include a metal-containing layer for controlling a work function and a gap-fill metal-containing layer for filling the upper space of the metal-containing layer for controlling a work function. In some example embodiments, the first and second gate electrode-forming layers GE1 and GE2 may have a structure in which a metal nitride layer, a metal layer, a conductive capping layer, and a gap-fill metal layer are sequentially stacked on each other. In some example embodiments, the first and second gate electrode-forming layers GE1 and GE2 may include different materials.

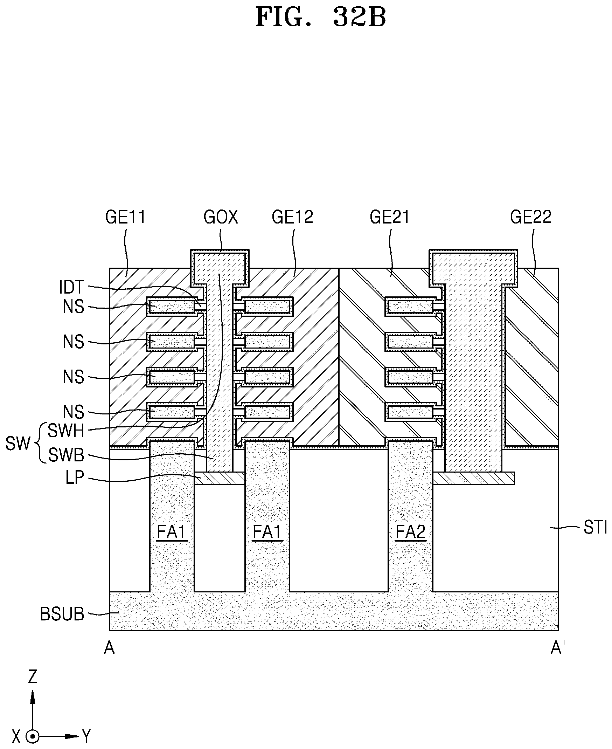

Referring to FIGS. 32A and 32B together, upper portions of the first and second gate electrode-forming layers GE1 and GE2 (see FIG. 32A) may be removed so that the head SWH of the sheet separation wall SW is at least partially exposed.

In some example embodiments, during the removal process, the gate dielectric film GOX may still remain to surround the head SWH of the sheet separation wall SW.

Accordingly, the first gate electrode-forming layer GE1 (see FIG. 32A) may be separated into a pair of first gate electrodes GE11 and GE12 that are not in contact with each other with the sheet separation wall SW therebetween. That is, the pair of first gate electrodes GE11 and GE12 may be electrically separated from each other.

Also, the second gate electrode-forming layer GE2 (see FIG. 32A) may be separated into a single second gate electrode GE21 and a single electrode structure GE22 that are not in contact with each other with the sheet separation wall SW therebetween.

In some example embodiments, the single electrode structure GE22 may not surround the plurality of nanosheets NS. That is, unlike the single second gate electrode GE21, the single electrode structure GE22 may not function as a gate electrode.

Referring back to FIG. 1, a gate capping layer GCL may be formed to cover the plurality of gate electrodes GE and the plurality of sheet separation walls SW. Specifically, the gate capping layer GCL may cover the upper surface and a portion of the sidewall of each of the heads SWH of the plurality of sheet separation walls SW.

Through the manufacturing process described above, the integrated circuit device 10 according to some example embodiments may be manufactured.

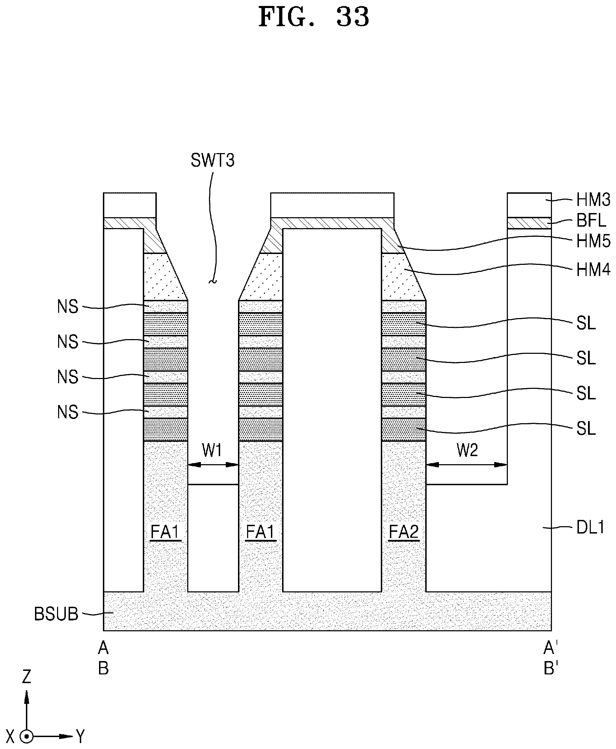

FIGS. 33 to 36 are cross-sectional views showing a method of manufacturing an integrated circuit device in a process sequence, according to some example embodiments.

A method of forming most of components, which are involved in the manufacturing method described below, is substantially the same as or similar to that described above with reference to FIGS. 4 to 32B. Therefore, for convenience of description, the description focuses on differences from the manufacturing method described above.

Referring to FIG. 33, a buffer layer BFL, a fifth hard mask pattern HM5, and a fourth hard mask pattern HM4 are patterned by using a third hard mask pattern HM3 as an etch mask. A plurality of third sheet separation trenches SWT3 are formed by partially performing an etching process on a first dielectric material layer DL1 exposed in the patterned result.

The etching process may include a dry or wet etching process. The fourth and fifth hard mask patterns HM4 and HM5 may be partially etched by the etching process, thereby forming a tapered shape in which the horizontal width decreases downward.

Also, sidewalls of a stack structure of a plurality of sacrificial layers SL and a plurality of nanosheets NS may be exposed in the plurality of third sheet separation trenches SWT3 by the etching process.

Accordingly, a lower portion of a third sheet separation trench SWT3 located on the left side in the diagram may have a first trench width W1, and a lower portion of a third sheet separation trench SWT3 located on the right side in the diagram may have a second trench width W2. The second trench width W2 may be greater than the first trench width W1.

This may be because the plurality of nanosheets NS are not formed on one side (the far right side in the diagram) of the third sheet separation trench SWT3 located on the right side in the diagram, and thus, a space in which the third sheet separation trenches SWT3 may be formed increases.

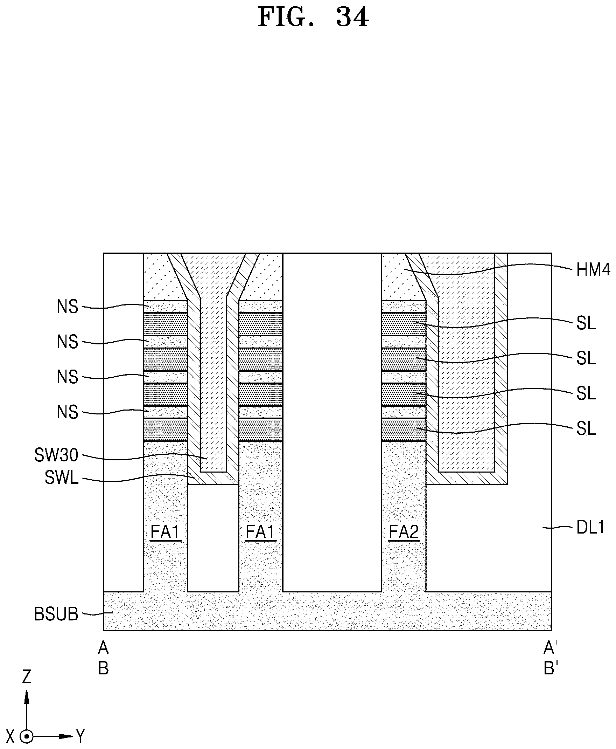

Referring to FIG. 34, the third hard mask pattern HM3 (see FIG. 33), the buffer layer BFL (see FIG. 33), and the fifth hard mask pattern HM5 (see FIG. 33) may be removed.

Accordingly, the upper surface of the fourth hard mask pattern HM4 and the uppermost surface of the first dielectric material layer DL1 may be exposed. In some example embodiments, the upper surface of the fourth hard mask pattern HM4 and the uppermost surface of the first dielectric material layer DL1 may have the same or substantially the same vertical level.

Next, a sheet separation liner SWL may be conformally formed along the inner wall of the plurality of third sheet separation trenches SWT3 (see FIG. 33). The sheet separation liner SWL may conformally cover a plurality of fourth hard mask patterns HM4, the plurality of nanosheets NS, the plurality of sacrificial layers SL, portions of first and second fin-type active regions FA1 and FA2, and an exposed surface of the first dielectric material layer DL1. Also, the sheet separation liner SWL may not fill the third sheet separation trench SWT3 (see FIG. 33).

Next, a sheet separation wall SW30 may be formed, which covers the sheet separation liner SWL and fills each of the plurality of third sheet separation trenches SWT3 (see FIG. 33). Accordingly, the upper surface of the sheet separation wall SW30, the uppermost surface of the sheet separation liner SWL, the upper surface of the fourth hard mask pattern HM4, and the uppermost surface of the first dielectric material layer DL1 may have the same or substantially the same vertical level.

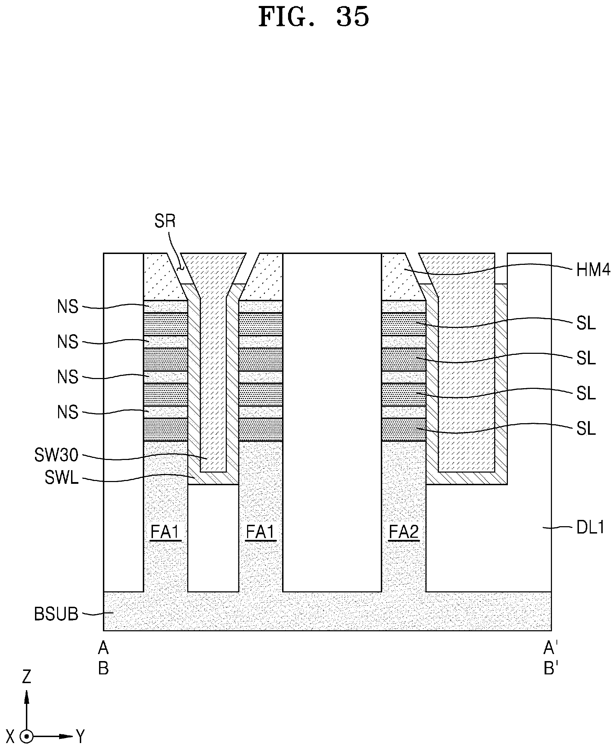

Referring to FIG. 35, an upper portion of the sheet separation liner SWL is removed partially. Accordingly, an upper recess SR may be formed, which exposes a sidewall of the fourth hard mask pattern HM4 and a sidewall of the sheet separation wall SW30.

In forming the upper recess SR, only the upper portion of the sheet separation liner SWL may be removed partially, due to the difference in the etch selectivities between materials forming both the fourth hard mask pattern HM4 and the sheet separation wall SW30 and materials forming the sheet separation liner SWL.

In some example embodiments, the vertical level of the bottom surface of the upper recess SR may be higher than the vertical level of the lower surface of the fourth hard mask pattern HM4.

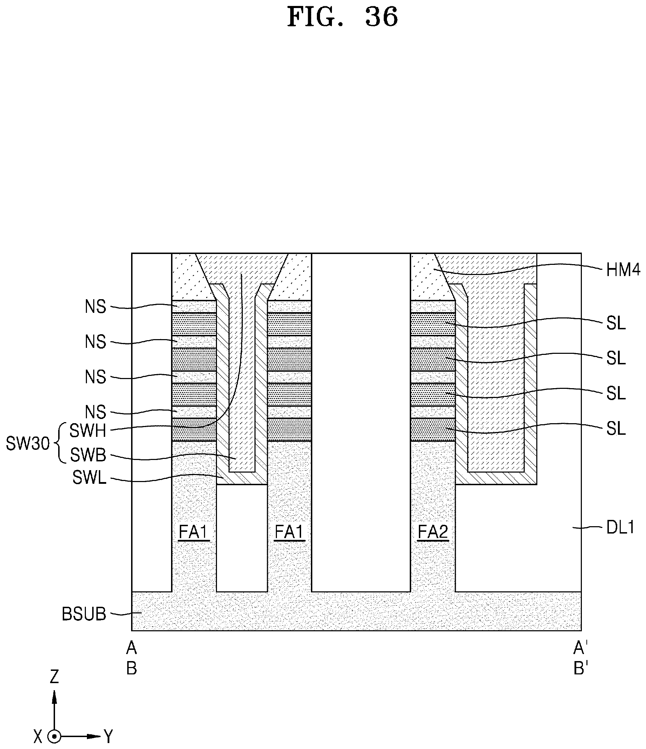

Referring to FIG. 36, a head SWH is formed by filling the upper recess SR (see FIG. 35). Accordingly, a nail-shaped sheet separation wall SW30 may be formed in which the head SWH is integrated with a body SWB.

Accordingly, the sheet separation wall SW30 may be changed into a shape that includes the body SWB having a first width and the head SWH having a second width greater than the first width. That is, the head SWH of the sheet separation wall SW30 may have an inverted trapezoidal shape in which the horizontal width decreases downward.

Referring back to FIG. 3, the integrated circuit device 30 according to some example embodiments may be manufactured by the manufacturing process described above.

When the terms "about" or "substantially" are used in this specification in connection with a numerical value, it is intended that the associated numerical value includes a manufacturing or operational tolerance (e.g., ±10 %) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10 %) around the stated numerical values or shapes.

## Claims

1. An integrated circuit device (10, 20, 30) comprising:
a base substrate layer (BSUB) comprising a pair of first fin-type active regions (FA1) and a single second fin-type active region (FA2), each extending in a first horizontal direction (X) and protruding in a vertical direction (Z), the pair of first fin-type active regions (FA1) and the single second fin-type active region (FA2) spaced apart from each other in a second horizontal direction (Y) intersecting the first horizontal direction (X);
a first liner pattern (LP1) extending in the second horizontal direction (Y) between the pair of first fin-type active regions (FA1) and in contact with facing sidewalls of the pair of first fin-type active regions (FA1);
a second liner pattern (LP2) extending in the second horizontal direction (Y) and in contact with one sidewall of the single second fin-type active region (FA2);
a first sheet separation wall (SW1) on the first liner pattern (LP1) and comprising a body (SWB) having a first width (A1B) and a head (SWH) having a second width (A1H) greater than the first width (A1B);
a second sheet separation wall (SW2) on the second liner pattern (LP2) and comprising a body (SWB) having a third width (A2B) and a head (SWH) having a fourth width (A2H) greater than the third width (A2B);
a pair of first nanosheet stack structures (NSS1) each comprising a plurality of first nanosheets, the pair of first nanosheet stack structures (NSS1) respectively above the pair of first fin-type active regions (FA1) and spaced apart from each other in the second horizontal direction (Y) with the first sheet separation wall (SW1) therebetween;
a single second nanosheet stack structure (NSS2) comprising a plurality of second nanosheets, the second nanosheet stack structure (NSS2) above the single second fin-type active region (FA2);
a plurality of indent spacers (IDT) between the plurality of first nanosheets and the first sheet separation wall (SW1) and between the plurality of second nanosheets and the second sheet separation wall (SW2);
a pair of first gate electrodes (GE11, GE12) respectively surrounding the pair of first nanosheet stack structures (NSS1) with the first sheet separation wall (SW1) therebetween; and
a single second gate electrode (GE21) surrounding the single second nanosheet stack structure (NSS2).

2. The integrated circuit device (10, 20, 30) of claim 1, wherein
the first and second liner patterns (LP1, LP2) each have a rectangular shape with longer sides in the second horizontal direction (Y),
a horizontal width of the first liner pattern (LP1) in the second horizontal direction (Y) is equal to the second width (A1H) of the head (SWH) of the first sheet separation wall (SW1), and
a horizontal width of the second liner pattern (LP2) in the second horizontal direction (Y) is equal to the fourth width (A2H) of the head (SWH) of the second sheet separation wall (SW2).

3. The integrated circuit device (10, 20, 30) of claim 1 or 2, wherein
the first width (A1B) of the body (SWB) of the first sheet separation wall (SW1) is less than the third width (A2B) of the body (SWB) of the second sheet separation wall (SW2), and
the second width (A1H) of the head (SWH) of the first sheet separation wall (SW1) is less than the fourth width (A2H) of the head (SWH) of the second sheet separation wall (SW2).

4. The integrated circuit device (10, 20, 30) of any one of claims 1 to 3, wherein
the body (SWB) of each of the first and second sheet separation walls (SW1, SW2) has a rectangular shape with longer sides in the vertical direction (Z), and
the head (SWH) of each of the first and second sheet separation walls (SW1, SW2) has a rectangular shape with longer sides in the second horizontal direction (Y).

5. The integrated circuit device (30) of any one of claims 1 to 3, wherein
the body (SWB) of each of the first and second sheet separation walls (SW1, SW2) has a rectangular shape with longer sides in the vertical direction (Z), and
the head (SWH) of each of the first and second sheet separation walls (SW1, SW2) has an inverted trapezoidal shape with a horizontal width decreasing downward.

6. The integrated circuit device (10, 20, 30) of any one of claims 1 to 5, wherein a vertical level of an uppermost surface of each of the pair of first gate electrodes (GE11, GE12) is lower than a vertical level of an uppermost surface of the head (SWH) of the first sheet separation wall (SW1) and higher than a vertical level of a lowermost surface of the head (SWH) of the first sheet separation wall (SW1).

7. The integrated circuit device (10, 20, 30) of any one of claims 1 to 6, further comprising a gate capping layer (GCL) covering the pair of first gate electrodes (GE11, GE12) and the single second gate electrode (GE21).

8. The integrated circuit device (10, 20, 30) of claim 7, wherein the gate capping layer (GCL) covers an upper surface and a portion of a sidewall of the head (SWH) of each of the first and second sheet separation walls (SW1, SW2).

9. The integrated circuit device (10, 20, 30) of claim 7, a vertical level of a lowermost surface of the gate capping layer (GCL) is lower than a vertical level of an uppermost surface of the head (SWH) of each of the first and second sheet separation walls (SW1, SW2) and higher than a vertical level of a lowermost surface of the head (SWH) of each of the first and/second sheet separation walls (SW2).

10. The integrated circuit device (10, 20, 30) of any one of claims 1 to 9, wherein a vertical thickness of each of the plurality of first nanosheets and a vertical thickness of each of the plurality of second nanosheets are greater than a vertical thickness (C1) of each of the plurality of indent spacers (IDT).

11. The integrated circuit device (10, 20, 30) of any one of claims 1 to 10, further comprising a gate dielectric film (GOX) conformally surrounding the first and second nanosheets, the plurality of indent spacers (IDT), and the first and second sheet separation walls (SW1, SW2).

12. The integrated circuit device (10, 30) of claim 11, wherein the gate dielectric film (GOX) covers an upper surface of the head (SWH) of each of the first and second sheet separation walls (SW1, SW2).

13. The integrated circuit device (20) of claim 11, wherein an upper surface of the head (SWH) of each of the first and second sheet separation walls (SW1, SW2) is exposed through the gate dielectric film (GOX).

14. The integrated circuit device (10, 20, 30) of any one of claim 7 to 9 and any one of claims 11 to 13, wherein the gate capping layer (GCL) and the pair of first gate electrodes (GE11, GE12) cover the gate dielectric film (GOX).

15. The integrated circuit device (10, 20, 30) of any one of claims 1 to 14, wherein the pair of first fin-type active regions (FA1) are spaced apart from each other in the second horizontal direction.
